# EUROPEAN PATENT APPLICATION

(11) **EP 4 576 195 A2**
(43) Date of publication of application: **25.06.2025**
(21) Application number: 24216063.8
(22) Date of filing: 28.11.2024
(51) Int. Cl.: H01L 23/15, H01L 21/48, H01L 23/498, H01L 23/538

(54) **MICROELECTRONIC ASSEMBLIES WITH THROUGH-GLASS VIA STRESS ALLEVIATION IN GLASS CORES**

(30) Priority: 30.11.2023 US 202318523986
(71) Applicant: INTEL Corporation, Santa Clara, CA 95054 (US)
(72) Inventor: ABEYRATNE KURAGAMA, Peumie, Chandler, AZ 85286 (US); ANGOUA, Bainye, Chandler, AZ 85226 (US); ARRINGTON, Kyle Jordan, GILBERT, AZ 85297 (US); BAI, Yiqun, Chandler, AZ 85249 (US); BRYKS, Whitney, Tempe, AZ 85284 (US); CARRAZZONE, Ryan, Chandler, AZ 85226 (US); CHEN, Haobo, Chandler, AZ 85249 (US); FENG, Hongxia, Chandler, AZ 85249 (US); GRUJICIC, Darko, Chandler, AZ 85249 (US); GUO, Xiaoying, Chandler, AZ 85248 (US); HARIRI, Haifa, Phoenix, AZ 85045 (US); HEATON, Thomas S., Gilbert, AZ 85234 (US); KAVIANI, Shayan, Phoenix, AZ 85044 (US); LI, Yuqin, Chandler, AZ 85226 (US); LIN, Ziyin, Chandler, AZ 85226 (US); Manepalli, Rahul N., Chandler, AZ 85249 (US); MU, Bin, Tempe, AZ 85284 (US); MYERS, Logan, Chandler, AZ 85225 (US); NIE, Bai, Chandler, AZ 85249 (US); RAHMAN, Mohammad Mamunur, Gilbert, AZ 85298 (US); SENEVIRATNE, Dilan, Phoenix, AZ 85048 (US); TAVAKOLI, Elham, Phoenix, AZ 85048 (US); TRIPATHI, Astitva, Mesa, AZ 85212 (US); WAIMIN, Jose, Chandler, AZ 85226 (US); XU, Dingying, Chandler, AZ 85248 (US); SHAN, Bohan, Chandler, AZ 85226 (US); MOHAMMADIGHALENI, Mahdi, Phoenix, AZ 85048 (US); STACEY, Joshua, Chandler, AZ 85286 (US); ZAMANI, Ehsan, Phoenix, AZ 85048 (US); CANDADAI, Aaditya, Chandler, AZ 85226 (US); VEHONSKY, Jacob, Chandler, AZ 85224 (US); WANDERA, Daniel, Beaverton, OR 97005 (US); PAGE, Mitchell, Mesa, AZ 85206 (US); RAMANUJA PIETAMBARAM, Srinivas Venkata, Chandler, AZ 85249 (US); DUAN, Gang, Chandler, AZ 85248 (US); ECTON, Jeremy, Gilbert, AZ 85298 (US); MARIN, Brandon C., Gilbert, AZ 85234 (US); OZKAN, Onur, Scottsdale, AZ 85251 (US); BEJUGAM, Vinith, Mesa, AZ 85212 (US); PATTADAR, Dhruba, Chandler, AZ 85226 (US); HASIB, Amm, Chandler, AZ 85225 (US); HAEHN, Nicholas, Scottsdale, AZ 85251 (US); WATSON, Makoyi, Phoenix, AZ 85044 (US); THARMARAJAH, Sanjay, Queen Creek, AZ 85142 (US); GAMBA, Jason M., Gilbert, AZ 85298 (US)
(74) Representative: 2SPL Patentanwälte PartG mbB

(57) **Abstract**

Various techniques for alleviating (e.g., mitigating or reducing) stresses between glass core materials and electrically conductive materials deposited in through-glass vias (TGVs) and related devices and methods are disclosed. In one aspect, a microelectronic assembly includes a glass core having a first face and a second face opposite the first face, and a TGV extending through the glass core between the first face and the second face, wherein the TGV includes a conductive material and a buffer layer between the conductive material and the glass core, wherein a CTE of the buffer layer is smaller than a CTE of the conductive material.

## Description

### Background

For the past several decades, scaling of features in integrated circuits (ICs) has been a driving force behind an ever-growing semiconductor industry and emerging applications in fields such as big data, artificial intelligence, mobile communications, and autonomous driving. Scaling to smaller and smaller features enables increased densities of functional units on the limited real estate of semiconductor chips. For example, shrinking transistor size allows incorporation of an increased number of memory or logic devices on a chip, lending to the fabrication of products with increased capacity. The drive for the ever-increasing capacity, however, is not without issue. The necessity to optimize fabrication and performance of each component (e.g., of each transistor) is becoming increasingly significant.

Parallel to optimizations at the transistor level, advanced IC packaging landscape is rapidly evolving to accommodate performance expectations and requirements of shrinking transistor size. Multiple IC dies are now commonly coupled together in a multi-die IC package to integrate features or functionality and to facilitate connections to other components, such as package substrates. For example, IC packages may include an embedded multi-die interconnect bridge (EMIB) for coupling two or more IC dies.

Integration of multiple dies in a single IC package has tremendous benefits but adds additional complexities due to placing materials with different material properties in close proximity to one another. When an IC package undergoes multiple processing steps involving various temperatures and pressure loads, individual materials within the package may behave differently from one another, resulting in out of plane deformation of various layers, known as "package warpage." One way to address package warpage is to use stiffer cores to which different IC dies are attached. Recently, glass cores have been explored as alternatives to organic resin-based cores (e.g., cores based on using Ajinomoto Build-up Film(ABF)). Glass is considered more rigid than organic resin-based materials and has several advantages such as excellent thermal properties, low coefficient of thermal expansion (CTE), high electrical insulation, chemical resistance, optical transparency, and compatibility with advances semiconductor properties. However, a major challenge for widespread adoption of glass cores is the fact that glass is highly susceptible to damage due to mechanical and/or thermal stresses, e.g., damage due to stresses caused by through-glass vias (TGVs) filled with metals.

### Brief Description of the Drawings

Embodiments will be readily understood by the following detailed description in conjunction with the accompanying drawings. To facilitate this description, like reference numerals designate like structural elements. Embodiments are illustrated by way of example, not by way of limitation, in the figures of the accompanying drawings.
FIG. 1 is a schematic side, cross-sectional view of one example microelectronic assembly, according to some embodiments of the present disclosure.
FIG. 2 is a schematic side, cross-sectional view of another example microelectronic assembly, according to some embodiments of the present disclosure.
FIG. 3 illustrates surfaces of a glass core from which TGV stress may initiate, according to some embodiments of the present disclosure.
FIGS. 4A-4D illustrate cross-sectional side views of a glass core showing a process of depositing cationic and anionic polyelectrolytes on sidewalls of TGV openings to form a buffer layer, according to some embodiments of the present disclosure.
FIG. 5 illustrates a cross-sectional side view of a glass core with multiple layers of cationic and anionic polyelectrolytes on sidewalls of TGV openings, according to some embodiments of the present disclosure.
FIGS. 6A-6C illustrate cross-sectional side views of a glass core showing a process of depositing cationic rr-conjugated oligomers/polymers on sidewalls of TGV openings to form a buffer layer, according to some embodiments of the present disclosure.
FIGS. 7A-7C illustrate structural formulas of examples of cationic rr-conjugated oligomers/polymers, according to some embodiments of the present disclosure.
FIGS. 8A-8D illustrate cross-sectional side views of a glass core showing a process of using a polymer nanoemulsion to provide a buffer layer on sidewalls of TGV openings, according to some embodiments of the present disclosure.
FIGS. 9A-9D illustrate cross-sectional side views of a glass core showing the use of an organic sol-gel process to provide a buffer layer on sidewalls of TGV openings, according to some embodiments of the present disclosure.
FIGS. 10A-10D illustrate cross-sectional side views of a glass core showing a process of using a buffer layer based on vapor infiltration, according to some embodiments of the present disclosure.
FIGS. 11A-11C illustrate cross-sectional side views of a glass core showing a process of depositing other buffer layers on sidewalls of TGV openings, according to some embodiments of the present disclosure.
FIGS. 12A-12D illustrate TGVs with different patterns of conductive material and TGV stress resist material, according to some embodiments of the present disclosure.
FIGS. 13A-13C illustrate using polymer-filled TGVs to alleviate TGV stress, according to some embodiments of the present disclosure.
FIGS. 14A-14D illustrate cross-sectional side views of a glass core showing a process of glass core patterning to form conductive traces, according to some embodiments of the present disclosure.
FIG. 15 is a top view of a wafer and dies that may be included in a microelectronic assembly with a glass core in accordance with any of the embodiments disclosed herein, according to some embodiments of the present disclosure.
FIG. 16 is a side, cross-sectional view of an IC device that may be included in a microelectronic assembly with a glass core in accordance with any of the embodiments disclosed herein, according to some embodiments of the present disclosure.
FIG. 17 is a side, cross-sectional view of an IC device assembly that may include a glass core in accordance with any of the embodiments disclosed herein, according to some embodiments of the present disclosure.
FIG. 18 is a block diagram of an example communication device that may include a microelectronic assembly with a glass core in accordance with any of the embodiments disclosed herein, according to some embodiments of the present disclosure.

### Detailed Description

As described above, TGVs may contribute to mechanical and/or thermal stresses, making glass highly susceptible to damage. As the name suggests, TGVs are vias that extend between the bottom and top faces (or "faces") of a glass core. Once via openings are formed between the bottom and top faces of a glass core, the openings are filled with one or more electrically conductive materials (e.g., metals) to enable TGVs to support electrical connections through the glass core and/or support efficient thermal management by providing paths for heat dissipation from the active components to the package's external environment. TGVs enable more compact and efficient designs for microelectronic assemblies. However, integration of TGVs in glass cores is not trivial. One challenge arises from the differences in CTEs between materials that may be used for glass cores and metals deposited in the TGVs. CTE is a measure of how a material expands or contracts with changes in temperature and is typically defined as the fractional increase in length per unit rise in temperature, measured in, e.g., parts per million (ppm) per degrees Kelvin (K) or ppm/K. Metals and materials that may be used for glass cores have significantly different CTEs. Metals have relatively high CTEs, meaning that they may expand and contract significantly with changes in temperature. Glass, on the other hand, has a much lower CTE and is less responsive to temperature changes. For example, a CTE of glass may be on the order of about 3.5 ppm/K, while a CTE of a metal such as copper may be on the order of about 15 ppm/K. When a metal is in close contact with glass (e.g., a metal within a TGV in the glass core), and the assembly is exposed to temperature variations such as heating or cooling, the metal will heat up or cool down much faster, and to a greater extent, than the glass. This leads to the generation of significant thermal stress at the interface between the two materials. The high thermal stress can exceed the strength of the glass, leading to the formation of cracks, which may then propagate and compromise the structural integrity of the glass. Even if cracks don't form immediately, the repeated thermal cycling can gradually weaken the glass surface, potentially leading to the development of surface flaws or microcracks. Prolonged exposure to CTE mismatch-induced stresses can cause gradual degradation of the glass, making it more prone to failure over time.

Embodiments of the present disclosure relate to various techniques, as well as to related devices and methods, for alleviating (e.g., mitigating or reducing) CTE mismatch-induced stresses caused by the proximity of conductive materials of TGVs to glass materials of the glass cores. As used herein, such stresses are referred to as "TGV stress." As used herein, a glass core and a TGV to which one or more techniques for TGV stress alleviation as described herein have been applied are referred to as, respectively, a "glass core with TGV stress alleviation" and a "TGV with stress alleviation." In one aspect of the present disclosure, a microelectronic assembly includes a glass core having a first face and a second face opposite the first face, and a TGV extending through the glass core between the first face and the second face, wherein the TGV includes a conductive material and a buffer layer between the conductive material and the glass core, wherein a CTE of the buffer layer is smaller than a CTE of the conductive material. In another aspect of the present disclosure, a microelectronic assembly includes a via extending from a first side of the rectangular prism volume to a second side of the rectangular prism volume, the via including a metal, wherein the via has a first thickness in a first plane parallel to the first side, a second thickness in a second plane parallel to the first side, and a third thickness in a third plane parallel to the first side, and wherein the second plane is between the first plane and the third plane, the second thickness is smaller than the first thickness and the third thickness, the via further includes a filler material, the metal is between the glass of the rectangular prism volume and the filler material, and a CTE of the filler material is smaller than a CTE of the metal.

Integration of conductive materials of TGVs in glass cores used in microelectronic assemblies is challenging due to CTE mismatch, among others. Providing microelectronic assemblies with glass cores to which one or more techniques for TGV stress alleviation as described herein have been applied may help. Various ones of the embodiments disclosed herein may help achieve reliable integration of TGVs within a glass core at a lower cost and/or with greater design flexibility, relative to conventional approaches. Various ones of the glass cores with TGV stress alleviation disclosed herein may exhibit reduced susceptibility to fracture, relative to conventional approaches. Microelectronic assemblies with TGV stress alleviation in glass cores disclosed herein may be particularly advantageous for small and low-profile applications in computers, tablets, industrial robots, and consumer electronics (e.g., wearable devices).

In the following detailed description, reference is made to the accompanying drawings that form a part hereof wherein like numerals designate like parts throughout, and in which is shown, by way of illustration, embodiments that may be practiced. It is to be understood that other embodiments may be utilized, and structural or logical changes may be made, without departing from the scope of the present disclosure. Therefore, the following detailed description is not to be taken in a limiting sense.

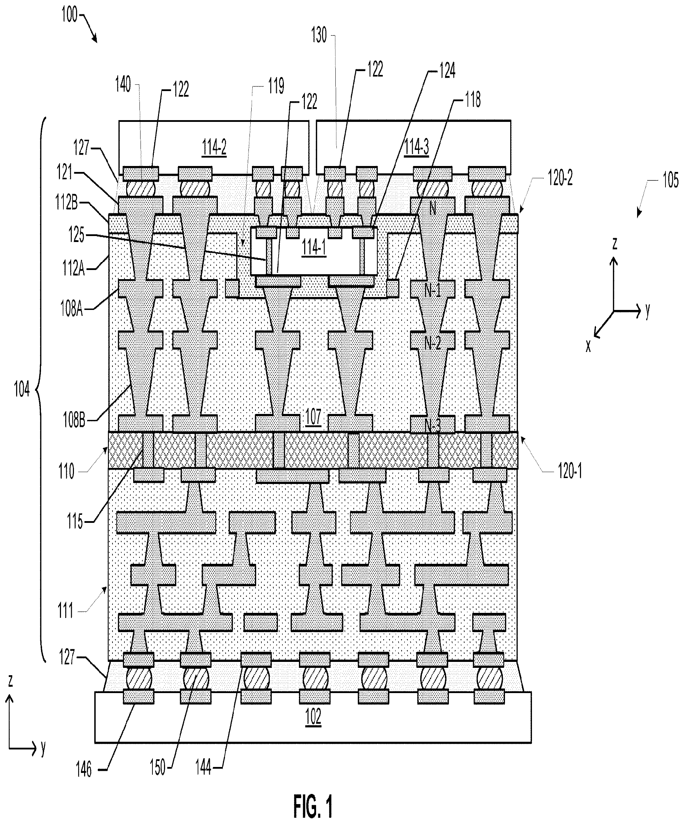

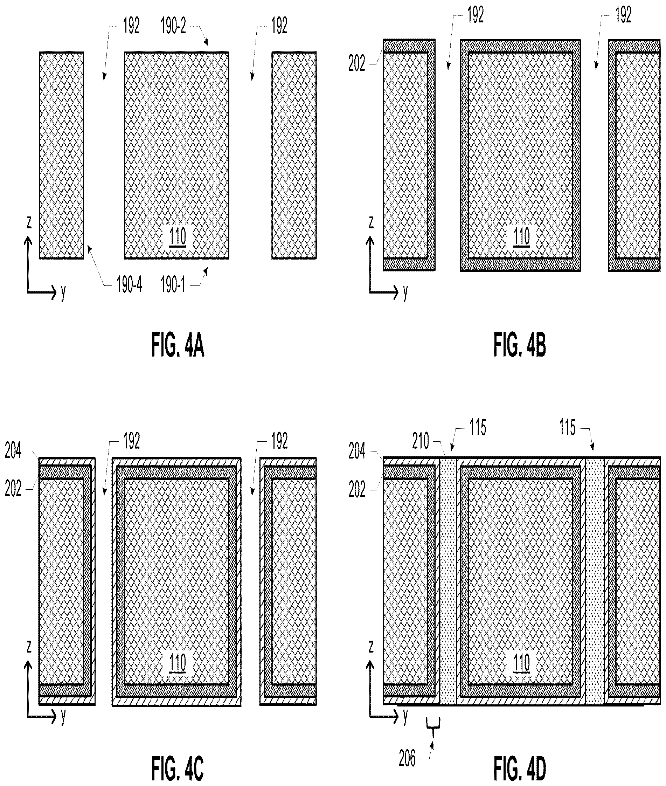

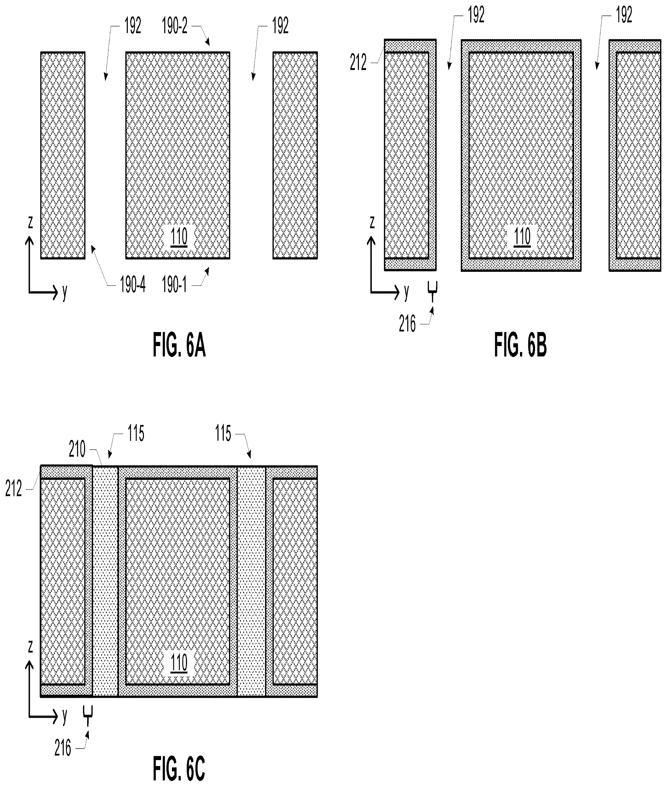

Any of the features discussed with reference to any of accompanying drawings herein may be combined with any other features to form a microelectronic assembly 100, a glass core 110, an IC device 1600, an IC device assembly 1700, or a communication device 1800, as appropriate. For convenience, the phrase "dies 114" may be used to refer to a collection of dies 114-1, 114-2, and so on, etc. A collection of drawings labeled with different letters may be referred to without the letters, e.g., a collection of FIGS. 4A-4D may be referred to as "FIG. 4," a collection of FIGS. 6A-6C may be referred to as "FIG. 6," etc. A number of elements of the drawings with same reference numerals may be shared between different drawings; for ease of discussion, a description of these elements provided with respect to one of the drawings is not repeated for the other drawings, and these elements may take the form of any of the embodiments disclosed herein. To not clutter the drawings, if multiple instances of certain elements are illustrated, only some of the elements may be labeled with a reference numeral (e.g., a plurality of conductive contacts 122 are shown in FIG. 1 but only one of the them is labeled with a reference numeral). Also to not clutter the drawings, not all reference numerals shown in one of the drawings are shown in other similar drawings.

The drawings are not necessarily to scale. Although many of the drawings illustrate rectilinear structures with flat walls and right-angle corners, this is simply for ease of illustration and may not reflect real-life process limitations which may cause various features to not look so "ideal" when any of the structures described herein are examined using e.g., scanning electron microscopy (SEM) images or transmission electron microscope (TEM) images. In such images of real structures, possible processing defects could also be visible, e.g., not-perfectly straight edges of materials, tapered vias or other openings, inadvertent rounding of corners or variations in thicknesses of different material layers. There may be other defects not listed here but that are common within the field of semiconductor device fabrication and packaging. Inspection of layout and mask data and reverse engineering of parts of a device to reconstruct the circuit using e.g., optical microscopy, TEM, or SEM, and/or inspection of a cross-section of a device to detect the shape and the location of various device elements described herein using, e.g., Physical Failure Analysis (PFA) would allow determination of presence of a glass core with TGV stress alleviation as described herein.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B, and C). When used to describe a range of dimensions, the phrase "between X and Y" represents a range that includes X and Y. When used to describe a location of an element, the phrase "between X and Y" represents a region that is spatially between element X and element Y. The terms "substantially," "close," "approximately," "near," and "about," generally refer to being within +/- 20%, e.g., within +/- 5% or within +/- 2%, of a target value based on the context of a particular value as described herein or as known in the art. Similarly, terms indicating orientation of various elements, e.g., "coplanar," "perpendicular," "orthogonal," "parallel," or any other angle between the elements, generally refer to being within +/- 10%, e.g., within +/- 5% or within +/- 2%, of the exact orientation.

The description uses the phrases "in an embodiment" or "in embodiments," which may each refer to one or more of the same or different embodiments. Furthermore, the terms "comprising," "including," "having," and the like, as used with respect to embodiments of the present disclosure, are synonymous. As used herein, the terms "package" and "IC package" are synonymous, as are the terms "die" and "IC die." Furthermore, the terms "chip," "chiplet," "die," and "IC die" may be used interchangeably herein.

Although certain elements may be referred to in the singular herein, such elements may include multiple sub-elements. For example, "a dielectric material" may include one or more dielectric materials or "an insulator material" may include one or more insulator materials. The terms "oxide," "carbide," "nitride," etc. refer to compounds containing, respectively, oxygen, carbon, nitrogen, etc. The term "high-k dielectric" refers to a material having a higher dielectric constant than silicon oxide, while the term "low-k dielectric" refers to a material having a lower dielectric constant than silicon oxide. The term "insulating" and variations thereof (e.g., "insulative" or "insulator") means "electrically insulating," the term "conducting" and variations thereof (e.g., "conductive" or "conductor") means "electrically conducting," unless otherwise specified. With reference to optical signals and/or devices, components and elements that operate on or using optical signals, the term "conducting" can also mean "optically conducting." The term "insulating material" refers to solid materials (and/or liquid materials that solidify after processing as described herein) that are substantially electrically nonconducting. They may include, as examples and not as limitations, organic polymers and plastics, and inorganic materials such as ionic crystals, porcelain, glass, silicon and alumina or a combination thereof. They may include dielectric materials, high polarizability materials, and/or piezoelectric materials. They may be transparent or opaque without departing from the scope of the present disclosure. Further examples of insulating materials are underfills and molds or mold-like materials used in packaging applications, including for example, materials used in organic interposers, package supports and other such components.

FIG. 1 is a schematic side, cross-sectional view of one example microelectronic assembly 100 in which a glass core with TGV stress alleviation as described herein may be implemented, according to some embodiments of the present disclosure. The microelectronic assembly 100 may include a substrate 107 with a double-sided bridge die 114-1 in a cavity 119 in the substrate 107, the die 114-1 may be electrically coupled to a conductive pathway, e.g., a conductive trace 108A or a conductive via 108B, in a metal layer N-1 of the substrate 107 that is beneath a bottom of the cavity 119. The substrate 107 may include a dielectric material 112 (e.g., a first dielectric material layer 112A and a second dielectric material layer 112B, as shown, together referred to as "one or more dielectric material layers 112") and a conductive material 108 arranged in the one or more dielectric material layers 112 to provide conductive pathways (e.g., conductive traces 108A and conductive vias 108B) through the substrate 107, as well as to provide conductive pads and contacts. The substrate 107 may include a first surface 120-1 and an opposing second surface 120-2. The die 114-1 may be surrounded by the dielectric material 112 of the substrate 107. The die 114-1 may include a bottom face (e.g., the surface facing towards the first surface 120-1) with first conductive contacts 122, an opposing top face (e.g., the surface facing towards the second surface 120-2) with second conductive contacts 124, and through-silicon vias (TSVs) 125 coupling respective first and second conductive contacts 122, 124. In some embodiments, a pitch of the first conductive contacts 122 on the first die 114-1 maybe between 25 microns and 250 microns. As used herein, pitch is measured center-to-center (e.g., from a center of a conductive contact to a center of an adjacent conductive contact). In some embodiments, a pitch of the second conductive contacts 124 on the first die 114-1 maybe between 25 microns and 100 microns. The dies 114-2, 114-3 may include a set of conductive contacts 122 on the bottom face of the die (e.g., the surface facing towards the first surface 120-1). The die 114 may include other conductive pathways (e.g., including lines and vias) and/or to other circuitry (not shown) coupled to the respective conductive contacts (e.g., conductive contacts 122, 124) on the surface of the die 114. As used herein, the terms "die," "microelectronic component," and similar variations may be used interchangeably. As used herein, the terms "interconnect component," "bridge die," and similar variations may be used interchangeably. The bridge die 114-1 may be electrically coupled to dies 114-2, 114-3 by die-to-die (DTD) interconnects 130 at a second surface 120-2. In particular, conductive contacts 124 on a top face of the die 114-1 may be coupled to conductive contacts 122 on a bottom face of dies 114-2, 114-3 by conductive vias 108B through the second dielectric material layer 112B.

As used herein, a "conductive contact" may refer to a portion of conductive material (e.g., metal) serving as an electrical interface between different components (e.g., part of a conductive interconnect); conductive contacts may be recessed in, flush with, or extending away (e.g., having a pillar shape) from a surface of a component, and may take any suitable form (e.g., a conductive pad or socket, or portion of a conductive line or via). In a general sense, an "interconnect" refers to any element that provides a physical connection between two other elements. For example, an electrical interconnect provides electrical connectivity between two electrical components, facilitating communication of electrical signals between them; an optical interconnect provides optical connectivity between two optical components, facilitating communication of optical signals between them. As used herein, both electrical interconnects and optical interconnects are comprised in the term "interconnect." The nature of the interconnect being described is to be understood herein with reference to the signal medium associated therewith. Thus, when used with reference to an electronic device, such as an IC that operates using electrical signals, the term "interconnect" describes any element formed of a conductive material for providing electrical connectivity to one or more elements associated with the IC or/and between various such elements. In such cases, the term "interconnect" may refer to both conductive traces (also sometimes referred to as "metal traces," "lines," "metal lines," "wires," "metal wires," "trenches," or "metal trenches") and conductive vias (also sometimes referred to as "vias" or "metal vias"). Sometimes, conductive traces and vias may be referred to as "metal traces" and "metal vias", respectively, to highlight the fact that these elements include conductive materials such as metals. Likewise, when used with reference to a device that operates on optical signals as well, such as a photonic IC (PIC), "interconnect" may also describe any element formed of a material that is optically conductive for providing optical connectivity to one or more elements associated with the PIC. In such cases, the term "interconnect" may refer to optical waveguides (e.g., structures that guide and confine light waves), including optical fiber, optical splitters, optical combiners, optical couplers, and optical vias.

The die 114 disclosed herein may include an insulating material (e.g., a dielectric material formed in multiple layers, as known in the art) and multiple conductive pathways formed through the insulating material. In some embodiments, the insulating material of a die 114 may include a dielectric material, such as silicon dioxide, silicon nitride, oxynitride, polyimide materials, glass reinforced epoxy matrix materials, or a low-k or ultra low-k dielectric (e.g., carbon-doped dielectrics, fluorine-doped dielectrics, porous dielectrics, organic polymeric dielectrics, photo-imageable dielectrics, and/or benzocyclobutene-based polymers). In some embodiments, the insulating material of a die 114 may include a semiconductor material, such as silicon, germanium, or a III-V material (e.g., gallium nitride), and one or more additional materials. For example, an insulating material may include silicon oxide or silicon nitride. The conductive pathways in a die 114 may include conductive traces and/or conductive vias, and may connect any of the conductive contacts in the die 114 in any suitable manner (e.g., connecting multiple conductive contacts on a same surface or on different surfaces of the die 114). Example structures that may be included in the dies 114 disclosed herein are discussed below with reference to the IC device 1600. The conductive pathways in the dies 114 may be bordered by liner materials, such as adhesion liners and/or barrier liners, as suitable. In some embodiments, the die 114 is a wafer. In some embodiments, the die 114 is a monolithic silicon, a fan-out or fan-in package die, or a die stack (e.g., wafer stacked, die stacked, or multi-layer die stacked).

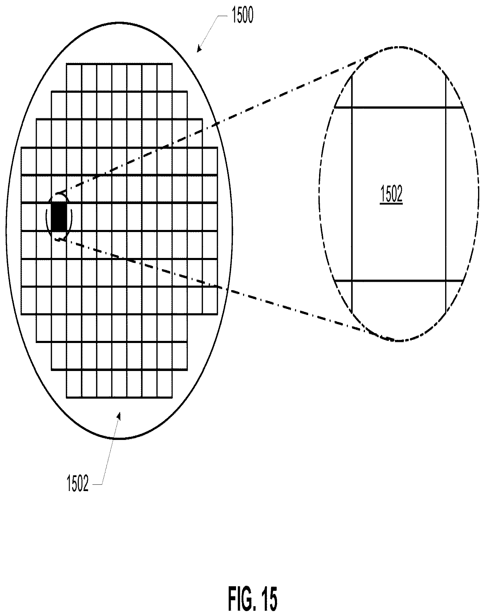

In some embodiments, the die 114 may include conductive pathways to route power, ground, and/or signals to/from other dies 114 included in the microelectronic assembly 100. For example, the die 114-1 may include TSVs 125, including a conductive via, such as a metal via, isolated from the surrounding silicon or other semiconductor material by a barrier oxide),or other conductive pathways through which power, ground, and/or signals may be transmitted between the package substrate 102 and one or more dies 114 "on top" of the die 114-1 (e.g., in the embodiment of FIG. 1, the dies 114-2 and/or 114-3). In some embodiments, the die 114-1 may not route power and/or ground to the dies 114-2 and 114-3; instead, the dies 114-2, 114-3 may couple directly to power and/or ground lines in the package substrate 102 by substrate-to-package substrate (STPS) interconnects 150, conductive pathways provided by the conductive material 108 in the substrate 107, and die-to-substrate (DTS) interconnects 140. In some embodiments, the die 114-1 may be thicker than the dies 114-2, 114-3. In some embodiments, the die 114-1 may be a memory device or a high frequency serializer and deserializer (SerDes), such as a Peripheral Component Interconnect (PCI) express. In some embodiments, the die 114-1 may be a processing die, a radio frequency chip, a power converter, a network processor, a workload accelerator, a voltage regulator die, or a security encryptor. In some embodiments, the die 114-2 and/or the die 114-3 may be a processing die, a radio frequency chip, a power converter, a network processor, a workload accelerator, a voltage regulator die, or a security encryptor. In some embodiments, the die 114 may be as described below with reference to the die 1502 of FIG. 15.

The dielectric material 112 of the substrate 107 may be formed in layers (e.g., at least a first dielectric material layer 112A and a second dielectric material layer 112B). In some embodiments, the dielectric material 112 may include an organic material, such as an organic build-up film. In some embodiments, the dielectric material 112 may include a ceramic, an epoxy film having filler particles therein, glass, an inorganic material, or combinations of organic and inorganic materials, for example. In some embodiments, the conductive material 108 may include a metal (e.g., copper). In some embodiments, the substrate 107 may include layers of dielectric material 112/conductive material 108, with lines/traces/pads/contacts (e.g., conductive traces 108A) of conductive material 108 in one layer electrically coupled to lines/traces/pads/contacts (e.g., conductive traces 108A) of conductive material 108 in an adjacent layer by vias (e.g., 108B) of the conductive material 108 extending through the dielectric material 112. Conductive elements 108A may be referred to herein as "conductive lines," "conductive traces," "conductive pads," or "conductive contacts." A substrate 107 including such layers may be formed using a printed circuit board (PCB) fabrication technique, for example.

An individual layer of dielectric material 112 (e.g., a first dielectric material layer 112A) may include a cavity 119 and the bridge die 114-1 may be at least partially nested in the cavity 119. The bridge die 114-1 may be surrounded by (e.g., embedded in) a next individual layer of dielectric material 112 (e.g., a second dielectric material layer 112B). In some embodiments, a cavity 119 is tapered, narrowing towards a bottom face of the cavity 119 (e.g., the surface towards the first surface 120-1 of the substrate 107). A cavity 119 may be indicated by a seam between the dielectric material 112A and the dielectric material 112B. As shown in FIG. 1, in cases where the bridge die 114-1 is partially nested in a cavity 119, a top face of the bridge die 114-1 may extend above a top face of dielectric material 112A. In cases where the bridge die 114-1 is fully nested in a cavity 119 (not shown), a top face of the bridge die 114-1 may be planar with or below a top face of dielectric material 112A.

A substrate 107 may include N layers of conductive material 108, where N is an integer greater than or equal to one. In FIG. 1, the layers are labeled in descending order from the second surface 120-2 (e.g., the top face) of the substrate 107 (e.g., layer N, layer N-1, layer N-2, etc.). In particular, as shown in FIG. 1, a substrate 107 may include four metal layers (e.g., N, N-1, N-2, and N-3). The N metal layer may include conductive contacts 121 at the second surface 120-2 of the substrate 107 that are coupled to conductive contacts 122 at bottom faces of the die 114-2, 114-3 by DTS interconnects 140. The N-2 metal layer may include conductive traces 108A having a top face (e.g., the surface facing towards the second surface 120-2 of the substrate 107), an opposing bottom face (e.g., the surface facing towards the first surface 120-1 of the substrate 107), and lateral surfaces extending between the top and bottom faces of the conductive traces 108A. A substrate 107 may further include an N-1 metal layer above the N-2 metal layer and below the N metal layer, where a portion of the N-1 metal layer includes a metal ring 118 exposed at a perimeter of the bottom of the cavity 119. The metal ring 118 may be coplanar with the conductive traces 108A of the N-1 metal layer and may be proximate to the edges of the cavity 119, as shown.

Although a particular number and arrangement of layers of dielectric material 112/conductive material 108 are shown in various ones of the accompanying figures, these particular numbers and arrangements are simply illustrative, and any desired number and arrangement of dielectric material 112/conductive material 108 may be used. Further, although a particular number of layers are shown in the substrate 107 (e.g., four layers), these layers may represent only a portion of the substrate 107, for example, further layers may be present (e.g., layers N-4, N-5, N-6, etc.).

As shown in FIG. 1, the substrate 107 may further include a glass core 110 with TGVs 115 and further layers 111 may be present below the glass core 110 and coupled to a package substrate 102 by interconnects 150. As used herein, the term "glass core" refers to a layer (e.g., a glass layer) or a structure (e.g., a portion of a glass layer) of any glass material such as quartz, silica, fused silica, silicate glass (e.g., borosilicate, aluminosilicate, alumino-borosilicate), soda-lime glass, soda-lime silica, borofloat glass, lead borate glass, photosensitive glass, non-photosensitive glass, or ceramic glass. In particular, the glass core 110 may be bulk glass or a solid volume/layer of glass, as opposed to, e.g., materials that may include particles of glass, such as glass fiber reinforced polymers (e.g., substrates/boards constructed of glass fibers and an epoxy binder). Such glass materials are typically non-crystalline, often transparent, amorphous solids. In some embodiments, the glass core 110 may be an amorphous solid glass layer. In some embodiments, the glass core 110 may include a material comprising silicon and oxygen, as well as any one or more of aluminum, boron, magnesium, calcium, barium, tin, sodium, potassium, strontium, phosphorus, zirconium, lithium, titanium, and zinc. In some embodiments, the glass core 110 may include a material, e.g., any of the materials described above, with a weight percentage of silicon being at least about 0.5%, e.g., between about 0.5% and 50%, between about 1% and 48%, or at least about 23%. For example, if the glass core 110 is fused silica, the weight percentage of silicon may be about 47%. In some embodiments, the glass core 110 may include a material having at least 23% silicon and/or at least 26% oxygen by weight, and, in some further embodiments, the glass core 110 may further include at least 5% aluminum by weight. In some embodiments, the glass core 110 may include any of the materials described above and may further include one or more additives such as Al₂O₃, B₂O₃, MgO, CaO, SrO, BaO, SnO₂, Na₂O, K₂O, SrO, P₂O₃, ZrO₂, Li₂O, Ti, and Zn. In some embodiments, the glass core 110 may be a layer of glass that does not include an organic adhesive or an organic material. The glass core 110 may be distinguished from, for example, the "prepreg" or "RF4" core of a PCB substrate which typically includes glass fibers embedded in a resinous organic material such as an epoxy. In such traditional cores/substrates including glass fibers and epoxy, the diameter of the glass fibers is generally in the range of 5 micron to 200 micron. In contract, the glass core 110 may be a layer of glass that is about 10 millimeters (mm) on a side to about 250 millimeters on a side (e.g., 10 millimeters x 10 millimeters to 250 millimeters x 250 millimeters). In some embodiments, a cross-section of the glass core 110 in an x-z plane, a y-z plane, and/or an x-y plane of an example coordinate system 105, shown in FIG. 1, may be substantially rectangular (axes shown in subsequent drawings refer to the axes of the coordinate system 105). In such embodiments, in the top-down view of the glass core 110 (e.g., the x-y plane of the coordinate system 105), the glass core 110 may have a first length in a range of 10 millimeters to 250 millimeters, and a second length in a range of 10 millimeters to 250 millimeters, the first length perpendicular to the second length. A thickness of the glass core 110 (e.g., a dimension measured along the z-axis of the coordinate system 105) may be in a range of about 50 micron to 1.4 millimeters. In some embodiments, the glass core 110 may be a glass core substrate, where the glass core substrate has a thickness in a range of about 50 microns to 1.4 millimeters. In some embodiments, the glass core 110 may be a layer of glass comprising a rectangular prism volume. In some such embodiments, the rectangular prism volume may have a first side and a second side perpendicular to the first side, the first side having a length in a range of 10 millimeters to 250 millimeters and the second side having a length in a range of 10 millimeters to 250 millimeters. In some embodiments, the glass core 110 may be a rectangular prism volume with sections (e.g., vias) removed and filled with other materials (e.g., metal) e.g., the TGVs 115. In some embodiments, the glass core 110 may be a layer of glass having a thickness in a range of 50 microns to 1.4 millimeters, a first length in a range of 10 millimeters to 250 millimeters, and a second length in a range of 10 millimeters to 250 millimeters, the first length perpendicular to the second length.

In some implementations, together, the substrate 107, including the glass core 110, and the dies 114 may be referred to as a "a multi-layer die subassembly 104." The glass core 110 may provide mechanical stability to the multi-layer die subassembly 104, the substrate 107, and/or the microelectronic assembly 100. The glass core 110 may reduce warpage and may provide a more robust surface for attachment of the multi-layer die subassembly 104 to a package substrate 102 or other substrate (e.g., an interposer or a circuit board).

In some implementations, together, the dielectric material 112 of the substrate 107 and the glass core 110 may be referred to as a "multi-layer glass substrate." In some such embodiments, the multi-layer glass substrate may be a coreless substrate. In some such embodiments, the glass core 110 may be a glass layer having a thickness in a range of about 25 microns to 50 microns. In some embodiments, the further layers 111 may also be part of the multi-layer glass substrate.

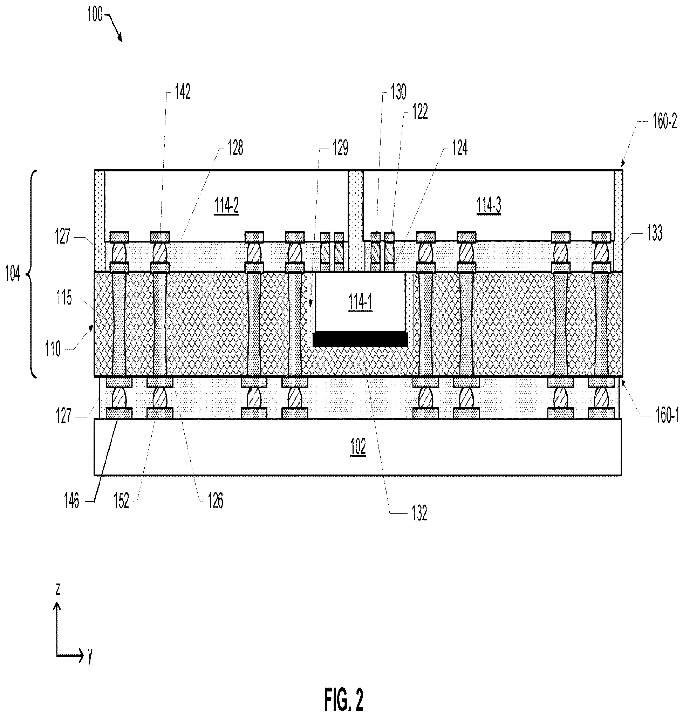

The TGVs 115 may be vias extending between a first side and a second side of the glass core 110 (e.g., between the bottom face and the top face of the glass core 110), the vias including any appropriate conductive material, e.g., a metal such as copper, silver, nickel, gold, aluminum, or other metals or alloys, for example. The TGVs 115 may be formed using any suitable process, including, for example, a direct laser drilling or laser induced deep etching process. In some embodiments, the TGVs 115 disclosed herein may have a pitch between 50 microns and 500 microns, e.g., as measured from a center of one TGV 115 to a center of an adjacent TGV 115. The TGVs 115 may have any suitable size and shape. In some embodiments, the TGVs 115 may have a circular, rectangular, or other shaped cross-section. In some embodiments, at least some of the TGVs 115 may have an hourglass shape, e.g., as shown in FIG. 2. In some embodiments, at least some of the TGVs 115 may taper down from one face of the glass core 110 to another, e.g., from the top face of the glass core 110 to the bottom face of the glass core 110. Any one of more of the TGVs 115 may be a TGV with stress alleviation as described herein. Therefore, the glass core 110 may be a glass core with TGV stress alleviation as described herein.

The substrate 107 (e.g., further layers 111) may be coupled to a package substrate 102 by STPS interconnects 150. In particular, the top face of the package substrate 102 may include a set of conductive contacts 146. Conductive contacts 144 on the bottom face of the substrate 107 may be electrically and mechanically coupled to the conductive contacts 146 on the top face of the package substrate 102 by the STPS interconnects 150. The package substrate 102 may include an insulating material (e.g., a dielectric material formed in multiple layers, as known in the art) and one or more conductive pathways to route power, ground, and signals through the dielectric material (e.g., including conductive traces and/or conductive vias, as shown). In some embodiments, the insulating material of the package substrate 102 may be a dielectric material, such as an organic dielectric material, a fire retardant grade 4 material (FR-4), bismaleimide triazine (BT) resin, polyimide materials, glass reinforced epoxy matrix materials, organic dielectrics with inorganic fillers or low-k and ultra low-k dielectric (e.g., carbon-doped dielectrics, fluorine-doped dielectrics, porous dielectrics, and organic polymeric dielectrics). In particular, when the package substrate 102 is formed using standard PCB processes, the package substrate 102 may include FR-4, and the conductive pathways in the package substrate 102 may be formed by patterned sheets of copper separated by build-up layers of the FR-4. The conductive pathways in the package substrate 102 may be bordered by liner materials, such as adhesion liners and/or barrier liners, as suitable. In some embodiments, the package substrate 102 may be formed using a lithographically defined via packaging process. In some embodiments, the package substrate 102 may be manufactured using standard organic package manufacturing processes, and thus the package substrate 102 may take the form of an organic package. In some embodiments, the package substrate 102 may be a set of redistribution layers formed on a panel carrier by laminating or spinning on a dielectric material, and creating conductive vias and lines by laser drilling and plating. In some embodiments, the package substrate 102 may be formed on a removable carrier using any suitable technique, such as a redistribution layer technique. Any method known in the art for fabrication of the package substrate 102 may be used, and for the sake of brevity, such methods will not be discussed in further detail herein.

In some embodiments, the package substrate 102 may be a lower density medium and the die 114 may be a higher density medium or have an area with a higher density medium. As used herein, the term "lower density" and "higher density" are relative terms indicating that the conductive pathways (e.g., including conductive interconnects, conductive lines, and conductive vias) in a lower density medium are larger and/or have a greater pitch than the conductive pathways in a higher density medium. In some embodiments, a higher density medium may be manufactured using a modified semi-additive process or a semi-additive build-up process with advanced lithography (with small vertical interconnect features formed by advanced laser or lithography processes), while a lower density medium may be a PCB manufactured using a standard PCB process (e.g., a standard subtractive process using etch chemistry to remove areas of unwanted copper, and with coarse vertical interconnect features formed by a standard laser process). In other embodiments, the higher density medium may be manufactured using semiconductor fabrication process, such as a single damascene process or a dual-damascene process. In some embodiments, additional dies may be disposed on the top face of the dies 114-2, 114-3. In some embodiments, additional components may be disposed on the top face of the dies 114-2, 114-3. Additional passive components, such as surface-mount resistors, capacitors, and/or inductors, may be disposed on the top face or the bottom face of the package substrate 102, or embedded in the package substrate 102.

The microelectronic assembly 100 of FIG. 1 may also include an underfill material 127. In some embodiments, the underfill material 127 may extend between the substrate 107 and the package substrate 102 around the associated STPS interconnects 150. In some embodiments, the underfill material 127 may extend between different ones of the top level dies 114-2, 114-3 and the top face of the substrate 107 around the associated DTS interconnects 140 and between the bridge die 114-1 and the top level dies 114-2, 114-3 around the DTD interconnects 130. The underfill material 127 may be an insulating material, such as an appropriate epoxy material. In some embodiments, the underfill material 127 may include a capillary underfill, non-conductive film (NCF), or molded underfill. In some embodiments, the underfill material 127 may include an epoxy flux that assists with soldering the multi-layer die subassembly 104 to the package substrate 102 when forming the STPS interconnects 150, and then polymerizes and encapsulates the STPS interconnects 150. The underfill material 127 may be selected to have a CTE that may mitigate or minimize the stress between the substrate 107 and the package substrate 102 arising from uneven thermal expansion in the microelectronic assembly 100. In some embodiments, the CTE of the underfill material 127 may have a value that is intermediate to the CTE of the package substrate 102 (e.g., the CTE of the dielectric material of the package substrate 102) and a CTE of the dies 114 and/or dielectric material 112 of the substrate 107.

The STPS interconnects 150 disclosed herein may take any suitable form. In some embodiments, a set of STPS interconnects 150 may include solder (e.g., solder bumps or balls that are subject to a thermal reflow to form the STPS interconnects 150), for example, as shown in FIG. 1, the STPS interconnects 150 may include solder between a conductive contacts 144 on a bottom face of the substrate 107 and a conductive contact 146 on a top face of the package substrate 102. In some embodiments, a set of STPS interconnects 150 may include an anisotropic conductive material, such as an anisotropic conductive film or an anisotropic conductive paste. An anisotropic conductive material may include conductive materials dispersed in a non-conductive material.

The DTD interconnects 130 disclosed herein may take any suitable form. The DTD interconnects 130 may have a finer pitch than the STPS interconnects 150 in a microelectronic assembly. In some embodiments, the dies 114 on either side of a set of DTD interconnects 130 may be unpackaged dies, and/or the DTD interconnects 130 may include small conductive bumps (e.g., copper bumps). The DTD interconnects 130 may have too fine a pitch to couple to the package substrate 102 directly (e.g., too fine to serve as DTS interconnects 140 or STPS interconnects 150). In some embodiments, a set of DTD interconnects 130 may include solder. In some embodiments, a set of DTD interconnects 130 may include an anisotropic conductive material, such as any of the materials discussed above. In some embodiments, the DTD interconnects 130 may be used as data transfer lanes, while the STPS interconnects 150 may be used for power and ground lines, among others. In some embodiments, some or all of the DTD interconnects 130 in a microelectronic assembly 100 may be metal-to-metal interconnects (e.g., copper-to-copper interconnects, or plated interconnects). In such embodiments, the DTD interconnect 130 may be bonded together (e.g., under elevated pressure and/or temperature) without the use of intervening solder or an anisotropic conductive material. Any of the conductive contacts disclosed herein (e.g., the conductive contacts 122, 124, 144, and/or 146) may include bond pads, solder bumps, conductive posts, or any other suitable conductive contact, for example. In some embodiments, some or all of the DTD interconnects 130 and/or the DTS interconnects 140 in a microelectronic assembly 100 may be solder interconnects that include a solder with a higher melting point than a solder included in some or all of the STPS interconnects 150. For example, when the DTD interconnects 130 and the DTS interconnects 140 in a microelectronic assembly 100 are formed before the STPS interconnects 150 are formed, solder-based DTD interconnects 130 and DTS interconnects 140 may use a higher-temperature solder (e.g., with a melting point above 200 degrees Celsius), while the STPS interconnects 150 may use a lower-temperature solder (e.g., with a melting point below 200 degrees Celsius). In some embodiments, a higher-temperature solder may include tin; tin and gold; or tin, silver, and copper (e.g., 96.5 % tin, 3% silver, and 0.5% copper). In some embodiments, a lower-temperature solder may include tin and bismuth (e.g., eutectic tin bismuth) or tin, silver, and bismuth. In some embodiments, a lower-temperature solder may include indium, indium and tin, or gallium.

In the microelectronic assemblies 100 disclosed herein, some or all of the DTS interconnects 140 and the STPS interconnects 150 may have a larger pitch than some or all of the DTD interconnects 130. DTD interconnects 130 may have a smaller pitch than STPS interconnects 150 due to the greater similarity of materials in the different dies 114 on either side of a set of DTD interconnects 130 than between the substrate 107 and the top level dies 114-2, 114-3 on either side of a set of DTS interconnects 140, and between the substrate 107 and the package substrate 102 on either side of a set of STPS interconnects 150. In particular, the differences in the material composition of a substrate 107 and a die 114 or a package substrate 102 may result in differential expansion and contraction due to heat generated during operation (as well as the heat applied during various manufacturing operations). To mitigate damage caused by this differential expansion and contraction (e.g., cracking, solder bridging, etc.), the DTS interconnects 140 and the STPS interconnects 150 may be formed larger and farther apart than DTD interconnects 130, which may experience less thermal stress due to the greater material similarity of the pair of dies 114 on either side of the DTD interconnects. In some embodiments, the DTS interconnects 140 disclosed herein may have a pitch between 25 microns and 250 microns. In some embodiments, the STPS interconnects 150 disclosed herein may have a pitch between 55 microns and 1000 microns, while the DTD interconnects 130 disclosed herein may have a pitch between 25 microns and 100 microns.

The microelectronic assembly 100 of FIG. 1 may also include a circuit board (not shown). The package substrate 102 may be coupled to the circuit board by second-level interconnects at the bottom face of the package substrate 102. The second-level interconnects may be any suitable second-level interconnects, including solder balls for a ball grid array arrangement, pins in a pin grid array arrangement or lands in a land grid array arrangement. The circuit board may be a motherboard, for example, and may have other components attached to it. The circuit board may include conductive pathways and other conductive contacts for routing power, ground, and signals through the circuit board, as known in the art. In some embodiments, the second-level interconnects may not couple the package substrate 102 to a circuit board, but may instead couple the package substrate 102 to another IC package, an interposer, or any other suitable component. In some embodiments, the substrate 107 may not be coupled to a package substrate 102, but may instead be coupled to a circuit board, such as a PCB.

Although FIG. 1 depicts a microelectronic assembly 100 having a substrate with a particular number of dies 114 and conductive pathways provided by the conductive material 108 coupled to other dies 114, this number and arrangement are simply illustrative, and a microelectronic assembly 100 may include any desired number and arrangement of dies 114. Although FIG. 1 shows the die 114-1 as a double-sided die and the dies 114-2, 114-3 as single-sided dies, the dies 114-2, 114-3 may be double-sided dies and the dies 114 may be a single-pitch die or a mixed-pitch die. In some embodiments, additional components may be disposed on the top face of the dies 114-2 and/or 114-3. In this context, a double-sided die refers to a die that has connections on both surfaces. In some embodiments, a double-sided die may include through TSVs to form connections on both surfaces. The active surface of a double-sided die, which is the surface containing one or more active devices and a majority of interconnects, may face either direction depending on the design and electrical requirements.

Many of the elements of the microelectronic assembly 100 of FIG. 1 are included in other ones of the accompanying drawings; the discussion of these elements is not repeated when discussing these drawings, and any of these elements may take any of the forms disclosed herein. Further, various elements are illustrated in FIG. 1 as included in the microelectronic assembly 100, but, in various embodiments, some of these elements may not be included. For example, in various embodiments, the further layers 111, the underfill material 127, and the package substrate 102 may not be present in the microelectronic assembly 100. In some embodiments, individual ones of the microelectronic assemblies 100 disclosed herein may serve as a system-in-package (SiP) in which multiple dies 114 having different functionality are included. In such embodiments, the microelectronic assembly 100 may be referred to as an SiP.

FIG. 2 is a schematic cross-sectional view of another example microelectronic assembly 100 according to some embodiments of the present disclosure. The configuration of the embodiment shown in the figure is like that of FIG. 1, except for differences as described further. Instead of including the glass core 110 as a part of the substrate 107, as was shown in FIG. 1, the microelectronic assembly 100 of FIG. 2 includes a glass core 110 on its own, where one or more dies 114 may be coupled to the glass core 110. In FIG. 2, the multi-layer die subassembly 104 includes the glass core 110 and the plurality of dies 114 as described above. The multi-layer die subassembly 104 may have a first surface 160-1 (e.g., the bottom face) and an opposing second surface 160-2 (e.g., the top face). The glass core 110 may provide mechanical stability to the multi-layer die subassembly 104 and/or the microelectronic assembly 100 of FIG. 2, may reduce warpage, and may provide a more robust surface for attachment of the multi-layer die subassembly 104 to a package substrate 102 or other substrate (e.g., an interposer or a circuit board).

The glass core 110 may include a cavity 129 with an opening facing the second surface 160-2 and the die 114-1 may be nested, fully or at least partially, in the cavity 129. As shown in FIG. 2, in cases where the die 114-1 is fully nested in a cavity 129, a top face of the die 114-1 may be planar with or below a top face of the glass core 110. In cases where the die 114-1 is partially nested in a cavity 129, a top face of the die 114-1 may extend above a top face of the glass core 110. The cavity 129 may be at least partially filled with a dielectric material 112A or 112B, described above. The die 114-1 may be attached to a bottom face of the cavity 129 by a die-attach film (DAF) 132. A DAF 132 may be any suitable material, including a non-conductive adhesive, die-attach film, a B-stage underfill, or a polymer film with adhesive property. A DAF 132 may have any suitable dimensions, for example, in some embodiments, a DAF 132 may have a thickness (e.g., height or z-height) between 5 microns and 10 microns.

The die 114-1 may be coupled to the dies 114-2, 114-3 in a layer above the die 114-1 through the DTD interconnects 130. The DTD interconnects 130 may be disposed between some of the conductive contacts 122 at the bottom of the dies 114-2, 114-3 and some of the conductive contacts 124 at the top of the die 114-1. Some other conductive contacts 122 at the bottom of the dies 114-2 and/or 114-3 may further couple one or more of the dies 114-2, 114-3 to the glass core 110 by glass core-to-die (GCTD) interconnects 142. The GCTD interconnects 142 may be disposed between some of the conductive contacts 122 at the bottom of the dies 114-2, 114-3 and some of the conductive contacts 128 at the top of the glass core 110. The GCTD interconnects 142 may be similar to the DTS interconnects 140, described above. In some embodiments, the underfill material 127 may extend between different ones of the dies 114 around the associated DTD interconnects 130 and/or GCTD interconnects 142. In some embodiments, a die 114-2 and/or a die 114-3 may be embedded in an insulating material 133. In some embodiments, an overall thickness (e.g., a z-height) of the insulating material 133 may be between 200 microns and 800 microns (e.g., substantially equal to a thickness of die 114-2 or 114-3 and the underfill material 127). In some embodiments, the insulating material 133 may form multiple layers (e.g., a dielectric material formed in multiple layers, as known in the art) and may embed one or more dies 114 in a layer. In some embodiments, the insulating material 133 may be a dielectric material, such as an organic dielectric material, a fire retardant grade 4 material (FR-4), BT resin, polyimide materials, glass reinforced epoxy matrix materials, or low-k and ultra low-k dielectric (e.g., carbon-doped dielectrics, fluorine-doped dielectrics, porous dielectrics, and organic polymeric dielectrics). In some embodiments, the insulating material 133 may be a mold material, such as an organic polymer with inorganic silica particles.

As shown in FIG. 2, the glass core 110 may further include conductive contacts 126 at the bottom of the glass core 110, and TGVs 115 may extend between and electrically couple conductive contacts 126 at the bottom of the glass core 110 and conductive contacts 128 at the top of the glass core 110. The conductive contacts 126, 128 may be similar to other conductive contacts disclosed herein (e.g., the conductive contacts 122, 124, 144, and/or 146), and may include bond pads, solder bumps, conductive posts, or any other suitable conductive contact, for example. As shown in FIG. 2, in some embodiments, at least some of the TGVs 115 may have an hourglass shape. For example, at least some of the TGVs 115 may has a first width at the first face of the glass core 110 (e.g., at the bottom face of the glass core 110), a second width at the second face of the glass core 110 (e.g., at the top face of the glass core 110), and a third width between the first face and the second face of the glass core 110, where the third width is smaller than the first width and the second width.

The dies 114-2, 114-3 may be electrically coupled to the package substrate 102 through the TGVs 115 and glass core-to-package substrate (GCTPS) interconnects 152, which may be power delivery interconnects or high-speed signal interconnects. The GCTPS interconnects 152 may be similar to the STPS interconnects 150, described above. The top face of the package substrate 102 may include a set of conductive contacts 146, the multi-layer die subassembly 104 may include a set of conductive contacts 126 on the first surface 160-1, and the GCTPS interconnects 152 may be between, and couple the conductive contacts 146 with corresponding ones of the conductive contacts 126. In some embodiments, the underfill material 127 may extend between the glass core 110 and the package substrate 102 around the associated GCTPS interconnects 152.

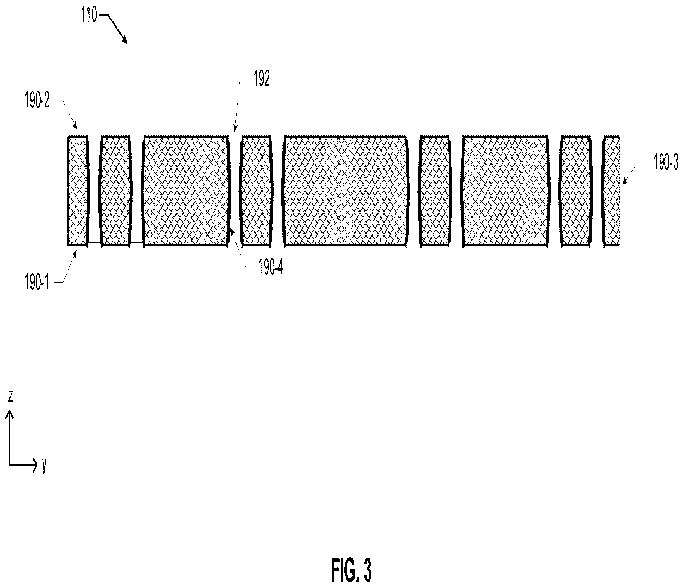

The glass core 110 included in a microelectronic assembly 100 as described with reference to FIG. 1 or FIG. 2 or included in any other microelectronic assembly or device, may be subject to TGV stress prior to inclusion in the microelectronic assembly 100. For example, FIG. 3 illustrates surfaces of a glass core 110 from which TGV stress may initiate, according to some embodiments of the present disclosure. As shown in FIG. 3, a glass core 110 may have a first face 190-1 and an opposing second face 190-2, which may be, e.g., bottom and top surfaces of the glass core 110 when the glass core 110 is included in a microelectronic assembly 100. The glass core 110 may also include a side 190-3, which is a surface of the glass core 110 that may be referred to as an edge or a side of the glass core 110, i.e., a surface that extends between the first face 190-1 and the second face 190-2. As further shown in FIG. 3, TGV openings 192 may be formed in the glass core 110, extending between the first face 190-1 and the second face 190-2. A sidewall 190-4 may then refer to one or more sidewalls of the TGV openings 192. When a conductive material is deposited in the TGV openings 192, TGV stress may initiate from the sidewall 190-4 due to CTE mismatch between the glass material of the glass core 110 and the conductive material in the TGV openings 192.

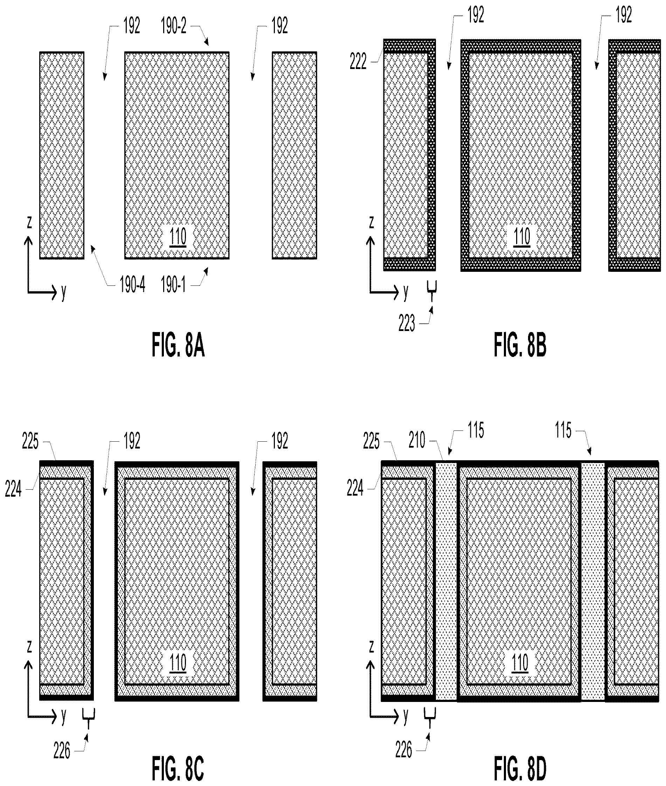

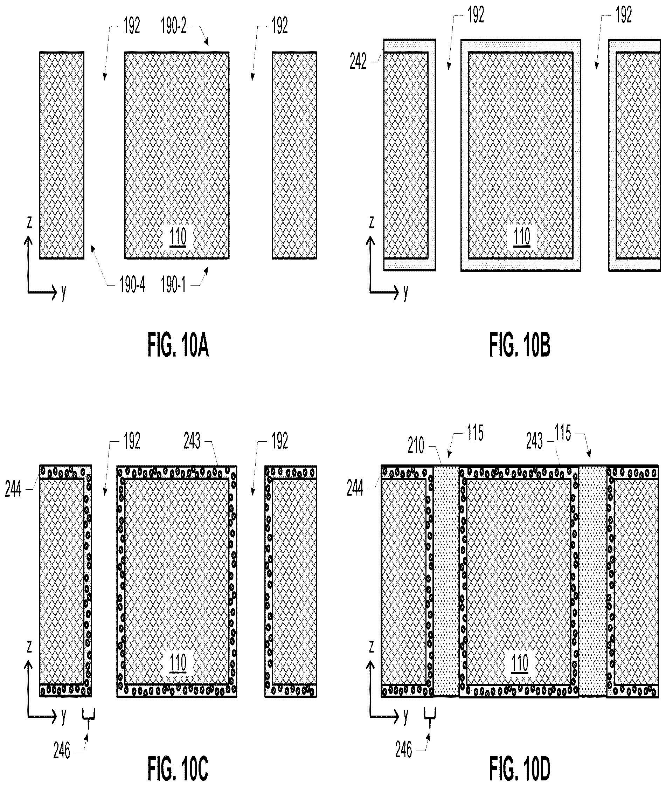

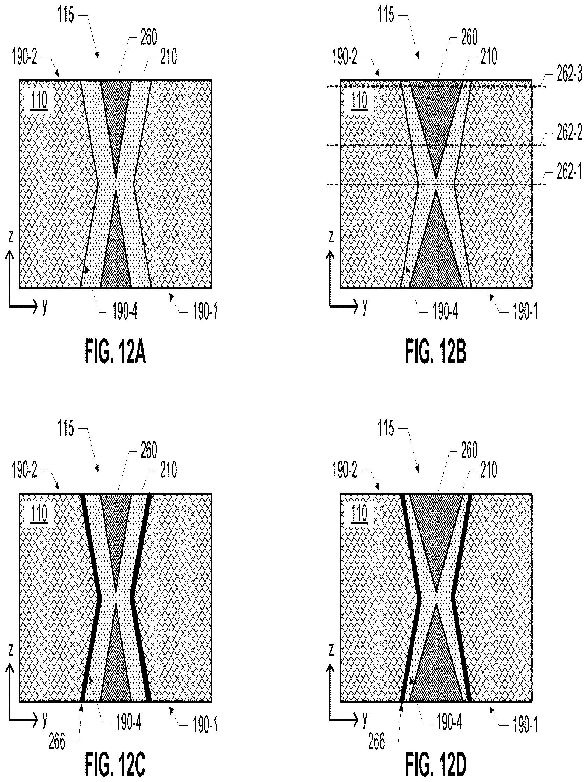

One or more techniques for TGV stress alleviation as described herein may be applied to reduce TGV stress at the sidewalls 190-4, before including the glass core 110 in a microelectronic assembly 100. At a high level, techniques described herein may be categorized as techniques based on providing a buffer layer between the glass material of the glass core 110 and the conductive material of the TGVs 115 (e.g., techniques illustrated in FIGS. 4-11) and techniques based on modifying the architecture and arrangement of the TGVs 115 (e.g., techniques illustrated in FIGS. 12-13). Techniques based on buffering TGV stress may further be categorized as techniques based on using surface-charge driven buffer coating (e.g., illustrated in FIGS. 4-7), techniques based on using porous buffer layer (e.g., techniques illustrated in FIGS. 8-9), and techniques based on using vapor deposition (e.g., techniques illustrated in FIGS. 10-11). In some embodiments, each of the techniques described herein may be implemented in a glass core 110 as the only technique to help alleviate TGV stress. In other embodiments, two or more different techniques described herein, in any combination, may be implemented in a glass core 110. Details of various techniques will now be described.

Techniques based on using surface-charge driven buffer coating for TGV stress alleviation may be based on deposition of one or more polymeric buffer layers. Examples of such techniques are described with reference to FIGS. 4-7. In particular, techniques based on using surface-charge driven buffer coating for TGV stress alleviation may include a technique using cationic and anionic polyelectrolytes (described with reference to FIGS. 4-5) and a technique using cationic rr-conjugated oligomers/polymers (described with reference to FIGS. 6-7).

FIGS. 4A-4D illustrate cross-sectional side views of a glass core showing a process of depositing cationic and anionic polyelectrolytes on sidewalls of TGV openings to form a buffer layer, according to some embodiments of the present disclosure. FIG. 4A illustrates that the process may begin with forming TGV openings 192 in a glass core 110. Although the TGV openings 192 are shown in FIG. 4A and many other subsequent drawings with straight sidewalls 190-4, in various embodiments the shape of the TGV openings 192 may be different, e.g., the shape may be hourglass shape as shown for the TGVs 115 of FIG. 2. After that, a layer-by-layer self-assembly may be performed to deposit cationic and anionic polyelectrolytes. Because glass has negative surface charge, the layer-by-layer self-assembly may begin by depositing cationic polyelectrolytes. In some embodiments, the negative charge on the surface of the sidewalls 190-4 may be native. In other embodiments, the glass core 110 may undergo special processing steps after formation of the TGV openings 192 and before the deposition of any polymeric buffer layers to provide/enhance the negative charge on the surface of the sidewalls 190-4. FIG. 4B illustrates the glass core 110 of FIG. 4A after deposition of a cationic polyelectrolyte 202. In some embodiments, a thickness of a single layer of the cationic polyelectrolyte 202 may be between about 1 nanometer and 500 nanometers, including all values and ranges therein, e.g., between about 1 nanometer and 300 nanometers, or between about 2 nanometers and 200 nanometers. One example of a material that may be used as the cationic polyelectrolyte 202 is poly(diallyldimethylammonium chloride) (PDDA). In other embodiments, the cationic polyelectrolyte 202 may include polyethylenimine. FIG. 4C illustrates the glass core 110 of FIG. 4B after deposition of an anionic polyelectrolyte 204. In some embodiments, a thickness of a single layer of the anionic polyelectrolyte 204 may be about the same as that of a single layer of the cationic polyelectrolyte 202. One example of a material that may be used as the anionic polyelectrolyte 204 is polystyrene sulfonate (PSS). In other embodiments, the anionic polyelectrolyte 204 may include sulfonated polysuflone (SPS). In some embodiments, processes such as slit-coating, spin-coating, spray-coating, dip-coating, or ink-jet printing may be used to deposit layers of the cationic polyelectrolyte 202 and the anionic polyelectrolyte 204, which may be simple and very cost-effective, in particular if compared to vacuum-based techniques such as chemical vapor deposition (CVD) for deposition of materials. In various embodiments, the layers of the cationic polyelectrolyte 202 and the anionic polyelectrolyte 204 on the sidewalls 190-4 of TGV openings 192 may be detected with vibrational spectroscopies such as Fourier Transform Infrared Spectroscopy (FTIR) and Raman spectroscopy, NMR, elemental analysis (XPS), imaging (e.g., AFM, SEM, or TEM).

In some embodiments, a single layer of the cationic polyelectrolyte 202 and a single layer of the anionic polyelectrolyte 204 in the buffer layer 206 may be sufficient to alleviate TGV stress. In such embodiments, after deposition of the anionic polyelectrolyte 204 a conductive material 210 may be deposited in the TGV openings 192, thus forming TGVs 115, as shown in FIG. 4D. The conductive material 210 may include any suitable conductive materials such as copper, silver, nickel, gold, aluminum, or other metals or alloys, for example, and may be deposited using techniques such as atomic level-deposition (ALD), physical vapor deposition (PVD) such as evaporation or sputtering, CVD, ALD, or electroplating.

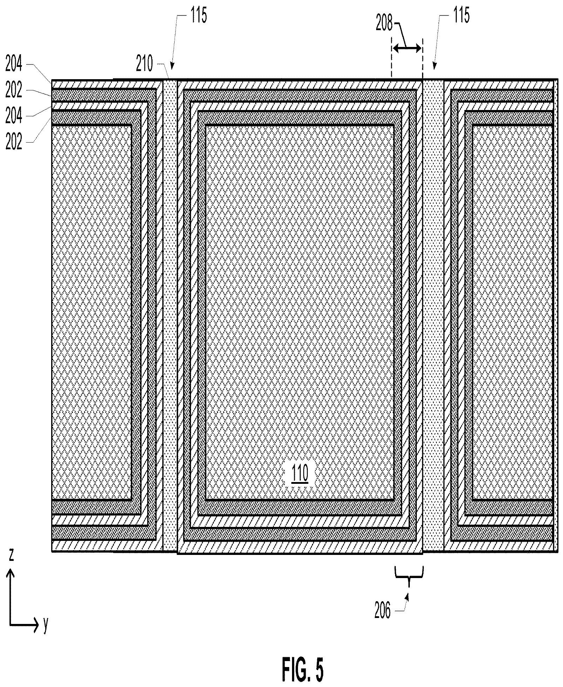

In other embodiments, multiple alternating layers of the cationic polyelectrolyte 202 and the anionic polyelectrolyte 204 may be deposited, e.g., to achieve a desired total thickness for the buffer layer 206 on the sidewall 190-4. An example of that is shown in FIG. 5, illustrating a glass core 110 similar to that shown in FIG. 4D, but with the buffer layer 206 including an additional pair of alternating layers of the cationic polyelectrolyte 202 and the anionic polyelectrolyte 204 added on top of what is shown in FIG. 4D. In various further embodiments, the number alternating layers of the cationic polyelectrolyte 202 and the anionic polyelectrolyte 204 may be even larger. To that end, self-assembly provide an efficient manner for easily modifying the thickness of the buffer layer 206 between the sidewall 190-4 and the conductive material 210, with a total thickness 208 of the buffer layer 206 on the sidewall 190-4 may be between about 2 nanometers and 20 microns, e.g., between about 2 nanometers and 10 microns, or between about 2 nanometers and 5 microns, or between about 10 nanometers and about 20 microns. Furthermore, if the last layer of the buffer layer 206 is the layer of the anionic polyelectrolyte 204, then some further embodiments may include depositing positively charged Pd2+ as catalyst for electroless deposition of the conductive material 210. This may help increase the catalyst adsorption on the surface of glass and, as a result, may increase the deposition of the conductive material 210 as an electroless conductive material on the surface.

FIGS. 4-5 illustrate TGV stress alleviation based on deposition of a buffer layer 206 formed by two or more alternating layers of the cationic polyelectrolyte 202 and the anionic polyelectrolyte 204. In other embodiments, a polymeric buffer layer similar to the buffer layer 206 may be formed using deposition of cationic rr-conjugated oligomers/polymers, illustrated with reference to FIGS. 6-7.

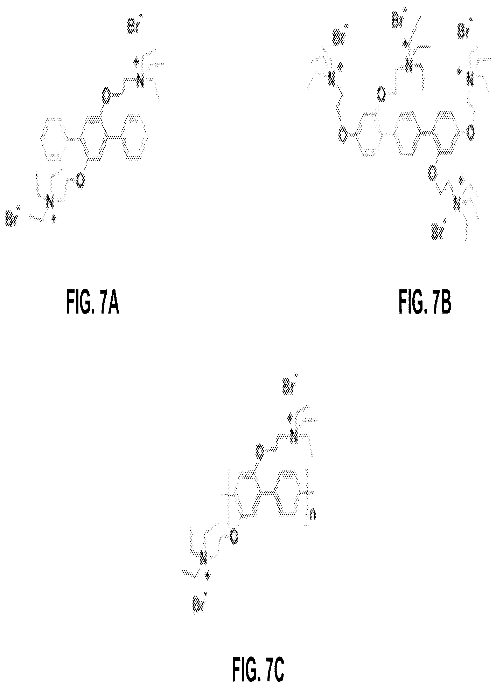

FIGS. 6A-6C illustrate cross-sectional side views of a glass core showing a process of depositing cationic rr-conjugated oligomers/polymers on sidewalls of TGV openings to form a buffer layer, according to some embodiments of the present disclosure. FIG. 6A illustrates that the process may begin with forming TGV openings 192 in a glass core 110, similar to those shown in FIG. 4A. After that, due to the native negative charge on the surface of the glass core 110 (which may be either native or supported by additional processing steps, as described with reference to FIGS. 4A-4D), cationic rr-conjugated oligomers and/or polymers may attach to the sidewall 190-4 of the TGV opening 192 to form a buffer layer 216. FIG. 6B illustrates the glass core 110 of FIG. 6A after deposition of a cationic rr-conjugated oligomer/polymer 212. In various embodiments, a thickness of the layer of the cationic rr-conjugated oligomer/polymer 212 may be between about 2 nanometers and 20 microns, e.g., between about 2 nanometers and 10 microns, or between about 2 nanometers and 5 microns, and may be adjusted as desired by adjusting the concentration of oligomer and/or polymers in the cationic rr-conjugated oligomer/polymer 212. In some embodiments, other deposition processes, e.g., spin-coating or dip-coating, may be used to deposit the cationic rr-conjugated oligomer/polymer 212. This deposition can make uniform layers on the sidewall 190-4 and surfaces of the glass core 110 since it is based on electrostatic interaction. After deposition of the buffer layer 216 the conductive material 210 may be deposited in the TGV openings 192, thus forming TGVs 115, as shown in FIG. 6C. FIGS. 7A-7C illustrate structural formulas of examples of the cationic rr-conjugated oligomers/polymers 212, according to some embodiments of the present disclosure. In particular, FIG. 7A illustrates synthesized cationic rr-conjugated oligomer 2QA-CCOE, FIG. 7B illustrates synthesized cationic rr-conjugated oligomer 4QA-CCOE, and FIG. 7C illustrates synthesized cationic rr-conjugated polymer CCPE.

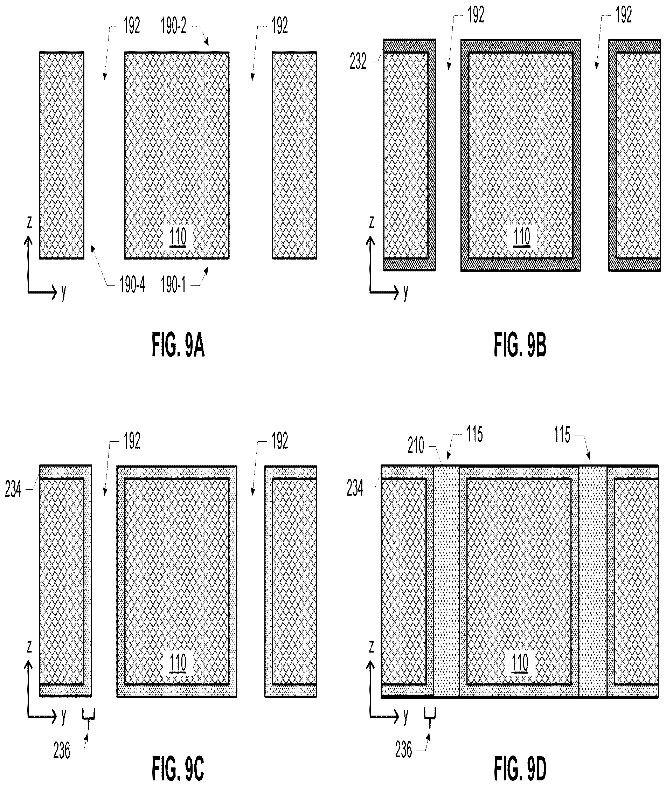

Techniques based on using porous buffer layer for TGV stress alleviation may include a technique using a polymer nanoemulsion buffer liner (described with reference to FIGS. 8A-8D) and a technique using a sol-gel process to provide a porous buffer layer (described with reference to FIGS. 9A-9D).

FIGS. 8A-8D illustrate cross-sectional side views of a glass core showing a process of using a polymer nanoemulsion to provide a buffer layer on sidewalls of TGV openings, according to some embodiments of the present disclosure. FIG. 8A illustrates that the process may begin with forming TGV openings 192 in a glass core 110, similar to those shown in FIG. 4A. After that, polymer nanoemulsion may be deposited on to the surfaces of the glass core 110, including the sidewalls 190-4. FIG. 8B illustrates the glass core 110 of FIG. 8A after deposition of a polymer nanoemulsion 222. In various embodiments, a thickness of a layer 223 of the polymer nanoemulsion 222 may be between about 1 nanometer and 75 microns, e.g., between about 1 nanometer and 50 microns, or between about 1 nanometer and 20 microns, and may be adjusted as desired by adjusting the concentration of the polymers in the polymer nanoemulsion 222. In various embodiments, processes such as slit-coating, spin-coating, spray-coating, dip-coating, or ink-jet printing may be used to deposit the polymer nanoemulsion 222. In some embodiments, the polymer nanoemulsion 222 may include polytetrafluoroethylene (PTFE) or other porous polymers. In some embodiments, the polymers of the polymer nanoemulsion 222 may have relatively low viscosity, e.g., between about 1 centipoise (cP) and 50 cP, to enable easier coating processes. Next, sintering may be applied to convert the polymer nanoemulsion 222 to a porous polymer structure 224, as is shown in FIG. 8C. In some embodiments, sintering may include heating the glass core of FIG. 8B to temperatures of about 390 degrees Celsius (C) for the duration of at least about 5 minutes. In some embodiments, a thickness of the porous polymer structure 224 may be between about 1 nanometer and 75 microns, e.g., between about 1 nanometer and 50 microns, or between about 1 nanometer and 20 microns. A layer of the porous polymer structure 224 may form a buffer layer 226 as a polymer nanoemulsion buffer liner that may alleviate TGV stress between the glass of the glass core 110 and the conductive material 210 deposited in the TGV openings 192 to form the TGVs 115, shown in FIG. 8D. In some embodiments, optionally, an ABF liner 225 (e.g., a layer comprising ABF) may further be deposited over the porous polymer structure 224. In this case, the buffer layer 226 may be a combination of the porous polymer structure 224 and the ABF liner 225, where the ABF liner 225 may enhance rigidity of the buffer layer 226. In some embodiments, a thickness of the ABF liner 225 may be between about 500 nanometer and about 10 microns, e.g., between about 1 micron and 5 microns. In other embodiments, the thickness of ABF liner 225 may be higher than 10 microns, as needed and as allowed by the dimensions of the TGV opening 192, provided that there should be space remaining for depositing the conductive material 210. In some embodiments, porosity of the porous polymer structure 224 may be relatively low to ensure that the dielectric constant of the porous polymer structure 224 is relatively low, e.g., less than about 2. In some embodiments, the porous polymer structure 224 may have relatively low Poisson's ratio, e.g., less than about 0.25, where the Poisson's ratio may be defined as the negative ratio of transverse strain to axial strain. In some embodiments, the porous polymer structure 224 may have relatively low Young's modulus, e.g., between about 1 gigapascal (GPa) and 10 GPa, where the Young's modulus may be defined as the ratio of stress to strain in a material undergoing deformation. In some embodiments, the porous polymer structure 224 may have relatively low CTE, e.g., between about 2 ppm/K and 15 ppm/K.

FIGS. 9A-9D illustrate cross-sectional side views of a glass core showing the use of an organic sol-gel process to provide a buffer layer on sidewalls of TGV openings, according to some embodiments of the present disclosure. FIG. 9A illustrates that the process may begin with forming TGV openings 192 in a glass core 110, similar to those shown in FIG. 4A. After that, a solution of a sol-gel material may be deposited on to the surfaces of the glass core 110, including the sidewalls 190-4. FIG. 9B illustrates the glass core 110 of FIG. 9A after deposition of a sol-gel material 232. To that end, a sol-gel process may be used to create the solution. The sol-gel process may involve conversion of monomers into a colloidal solution ("sol") that act as a precursor for an integrated network ("gel") of either discrete particles or network of polymers. In various embodiments, processes such as slit-coating, spin-coating, spray-coating, dip-coating, or ink-jet printing may be used to deposit the sol-gel material 232. In various embodiments, a thickness of the sol-gel material 232 may range from about 2 nanometers to 100s of microns, and may be adjusted as desired by adjusting the concentration of the monomers when preparing the sol-gel solution and the process parameters of the deposition method used. In some embodiments, the sol-gel material 232 may include metal alkoxides, such as aluminates, titanates and zirconates or non-metal alkoxides such as alkoxysilanes (tetramethoxysilane, tetraethoxysilane, tetrapropoxysilane, triethoxy(octyl)silane, trimethoxymethylsilane, trimethoxyphenylsilane, allyltrimethoxysilane) as precursors. In some embodiments, the solution of the sol-gel material 232 may have relatively low viscosity, e.g., between about 1 centipoise (cP) and 50 cP, to enable easier coating processes. The sol-gel process is a simple, convenient, and efficient process involving only hydrolysis and polycondensation reactions of metal alkoxide precursors. Next, softbake process may be applied to evaporate solvent from the sol-gel material 232, followed by cure process to enhance the mechanical properties and stability of the sol-gel material 232. As a result of applying softbake and cure, the sol-gel material 232 may be converted to a cured sol-gel material 234, as is shown in FIG. 9C. In some embodiments, softbake and cure may include heating the glass core of FIG. 9B to temperatures of between about 200 C and 500 C for the duration of at least 10 minutes. In some embodiments, a thickness of the cured sol-gel material 234 may be between about 1 nanometer and 1500 nanometers, e.g., between about 50 nanometers and 1200 nanometers, or between about 100 nanometers and 1000 nanometers. A layer of the cured sol-gel material 234 may form a buffer layer 236 as a sol-gel buffer liner that may alleviate TGV stress between the glass of the glass core 110 and the conductive material 210 deposited in the TGV openings 192 in a subsequent process, as is shown in FIG. 9D. In some embodiments, porosity of the cured sol-gel material 234 may be relatively low to ensure that the dielectric constant of the cured sol-gel material 234 is relatively low, e.g., between about 1.5 and 3, or between about 1.7 and 3, or between about 1.5 and 2.5. In some embodiments, the cured sol-gel material 234 may have relatively low Poisson's ratio, e.g., between 0.1 and about 0.25. In some embodiments, the cured sol-gel material 234 may have relatively low Young's modulus, e.g., between about 3 GPa and 10 GPa. In some embodiments, the cured sol-gel material 234 may have relatively low CTE (e.g., lower than that of the conductive material 210 deposited in the TGVs 115 as shown in FIG. 9D), e.g., between about 3 ppm/K and 20 ppm/K, e.g., between about 5 ppm/K and 12 ppm/K.

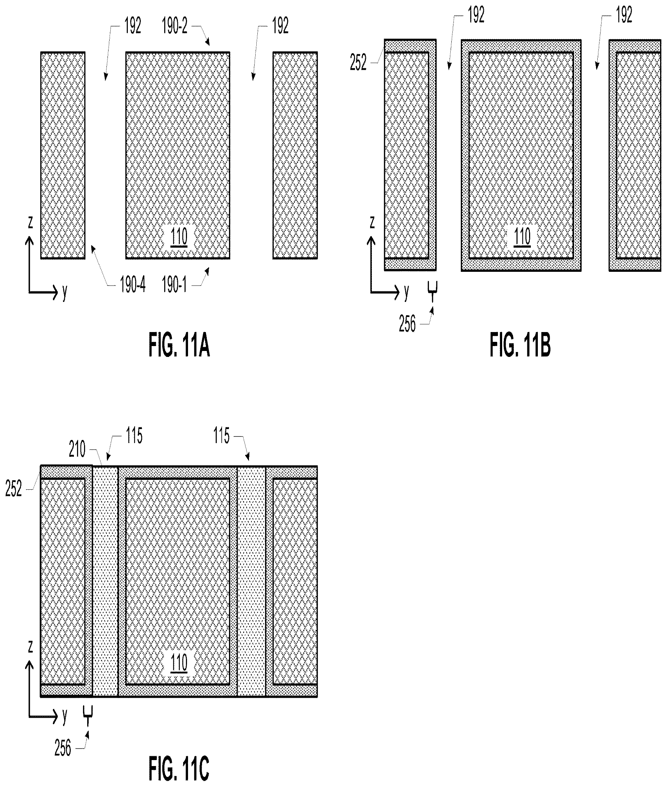

Techniques based on using vapor deposition for TGV stress alleviation may be based on, as the name suggests, vapor deposition of one or more polymeric buffer layers. Examples of such techniques are described with reference to FIGS. 10-11. In particular, techniques based on using vapor deposition for TGV stress alleviation may include a technique using a buffer layer and vapor infiltration (described with reference to FIGS. 10A-10D), and a technique using either initiated vapor deposition or an inorganic coating buffer layer (described with reference to FIGS. 11A-11C).

FIGS. 10A-10D illustrate cross-sectional side views of a glass core showing a process of using a buffer layer based on vapor infiltration, according to some embodiments of the present disclosure. FIG. 10A illustrates that the process may begin with forming TGV openings 192 in a glass core 110, similar to those shown in FIG. 4A. After that, a buffer material 242 may be deposited on surfaces and the sidewalls 190-4 of the TGV openings 192. FIG. 10B illustrates the glass core 110 of FIG. 11A after providing the buffer material 242. In some embodiments, the buffer material 242 may include a monomer, an oligomer, or a polymer. For example, the buffer material 242 may include polymers such as epoxy, PTFE, poly(1 ,3,5-trimethyl-1 ,3,5-trivinyl cyclotrisiloxane) (pV3D3), poly(1,3,5,7-tetravinyl-1,3,5,7-tetramethylcyclotetrasiloxane) (pV4D4), or pPFDA (poly(1H,1H,2H,2H-perfluorodecyl acrylate). In various embodiments, a thickness of the buffer material 242 on the sidewalls 190-4 may range from about 2 nanometers to 100s of microns, and may be adjusted as desired by adjusting the concentration of monomers, oligomers, and/or polymers during deposition of the buffer material 242. In some embodiments, the buffer material 242 may be deposited by vapor deposition. In other embodiments, processes such as slit-coating, spin-coating, spray-coating, dip-coating, or ink-jet printing may be used to deposit the buffer material 242. Next, as shown in FIG. 10C, particles 243 may be incorporated in the buffer material 242, thus converting the buffer material 242 into a processed buffer material 244 that includes the particles 243, and forming a buffer layer 246 of the processed buffer material 244. In some embodiments, the particles 243 may be deposited using vapor infiltration, e.g., using gas-phased vapor deposition using metal-containing precursors. The particles 243 may be selected as desired to change material properties of the buffer material 242 to, e.g., assist in alleviate TGV stress and/or to improve adhesion of the conductive material 210 (deposited in a subsequent process, as shown in FIG. 10D) to the sidewalls 190-4 of the TGVs, thus improving via reliability. For example, the particles 243 may be selected to modify the CTE of the buffer material 242 so that the CTE of the processed buffer material 244 is closer to that of the glass materials of the glass core 110. For example, in some embodiments, the CTE of the processed buffer material 244 may be relatively low and lower than that of the conductive material 210 deposited in the TGV a subsequent process, e.g., between about 3 ppm/K and 20 ppm/K, e.g., between about 5 ppm/K and 12 ppm/K. In some embodiments, the particles 243 may include inorganic particles that may include silicon (e.g., as a part of silica particles) or aluminum (e.g., as a part of alumina particles). Utilizing a filled buffer layer 246 using vapor infiltration deposition, a wider material selection is enabled to allow for improved adhesion between glass and the conductive material 210 and TGV stress alleviation at the sidewalls 190-4. In various embodiments, a thickness of the buffer layer 246 on the sidewalls 190-4 may be in about the same range as the thickness of the buffer material 242, described above. In some embodiments, the particles 243 may be incorporated into the buffer material 242 so that there is a change in concentration of the particles 243 throughout the thickness of the buffer layer 246. In particular, concentration of the particles may exhibit a gradient in that the particles 243 may have the largest concentration the further the particles are away from the glass core 110 and the concentration may decrease in portions of the buffer layer 246 that are closer to the glass core 110.

FIGS. 11A-11C illustrate cross-sectional side views of a glass core showing a process of depositing other buffer layers on sidewalls of TGV openings, according to some embodiments of the present disclosure. FIG. 11A illustrates that the process may begin with forming TGV openings 192 in a glass core 110, similar to those shown in FIG. 4A. After that, a buffer material 252 may be deposited on surfaces and the sidewalls 190-4 of the TGV openings 192 to form a buffer layer 256. FIG. 11B illustrates the glass core 110 of FIG. 11A after providing the buffer layer 256. After deposition of the buffer layer 256 the conductive material 210 may be deposited in the TGV openings 192, thus forming TGVs 115, as shown in FIG. 11C.

In some embodiments, the buffer material 252 may include polymers such as PTFE, poly(1,3,5-trimethyl-1,3,5-trivinyl cyclotrisiloxane) (pV3D3), poly(1,3,5,7-tetravinyl-1,3,5,7-tetramethylcyclotetrasiloxane) (pV4D4), or pPFDA (poly(1H,1H,2H,2H-perfluorodecyl acrylate). In such embodiments, the buffer material 252 may be deposited using an initiated CVD (iCVD) process. Monomers of such polymers are mainly made of carbon, nitrogen, oxygen, hydrogen, and other abundant elements, which make this class of material inexpensive. To complete the polymerization reaction on the surface, a thermally activated initiator radical activates the monomer on the surface (substrate), and polymerization starts on the surface. This characteristic provides the opportunity for grafting the polymer of the buffer material 252 to the substrates. Also, due to the nature of free radical polymerization, occurring during iCVD, it is possible to leave dangling bonds on the top surface of the buffer layer 256, providing grafting sites for the next layer that could be metal or other type of materials like polymers. Materials such as tert-butyl peroxide (TBPO) for PGMA or perfluoro butane sulfonyl fluoride (PBSF) may be used as initiators for the iCVD process. In various embodiments, a thickness of the buffer layer 256 formed by iCVD may be between about 1 nanometer and 75 microns, e.g., between about 1 nanometer and 50 microns, or between about 1 nanometer and 20 microns, and may be adjusted as desired by the deposition rate, deposition time, deposition pressure and/or precursors (i.e., initiator and monomer) flow rates. In some embodiments, the buffer layer 256 may include initiator molecules, used for initiation of reaction, which are unique to the use of iCVD and could be detected by performing analyses by, for example, x-ray photoelectron spectroscopy (XPS) or FTIR. In various embodiments, any of trifluoromethyl groups (e.g., -CF3 species), carbonyl groups (e.g., C=O species), ester groups (e.g., -O-C=O species), or sulfonyl groups may be detected in this manner and be indicative of the use of iCVD.

Use of the iCVD process may provide several advantages. One potential advantage is that iCVD deposition rate may be significantly faster compared to ALD and PVD techniques. Another potential advantage is that iCVD reactants, including monomer and initiator, may be made of abundant and cost-effective elements. Yet another potential advantage is that iCVD of polymers may enable the conformal deposition of high aspect ratio (>100). Furthermore, since reaction in iCVD starts on the substrate surface (e.g., glass, metal etc.), an improved chemical bonding to the metal and oxide surface may be realized, enabling very strong adhesion between the deposited buffer layer 256 and underlying surface independent of substrate roughness.

In other embodiments, the buffer material 252 may include organosilicates (e.g., compounds that contain both organic groups and silicon-oxygen (Si-O) bonds in their molecular structure, such as SiₓO_{y}C_{z}H or SiOC films) deposited on the sidewalls 190-4 as the buffer layer 256. These films have generally high tensile strengths, and the mechanical and dielectric properties are highly tunable based on the precursor types and ratios, process conditions, as well as the presence of added porogen species which can produce films with modulus values as low as 3-4GPa). In such embodiments, the buffer material 252 may be deposited using a plasma-enhanced CVD (PECVD) process. In various embodiments, a thickness of the buffer layer 256 formed by the organosilicate films may range from about 250 nanometers or 500 nanometers to about 10-20 microns, and may be adjusted as desired by deposition time, precursor gas flow rates, substrate temperature, radio frequency (RF) power, etc. In some embodiments, there may be characteristic features in the buffer layer 256 indicative of the use of the PECVD to deposit the buffer material 252, compared to other deposition techniques such as spin-coating or dip-coating. For example, PECVD films of the buffer material 252 described herein may have better three-dimensional cross-linking, resulting in the buffer material 252 being mechanically more robust (e.g., tougher or harder). In another example, conformality of PECVD films of the buffer material 252 described herein may be much higher than that of similar films deposited by other techniques. In yet another example, the film thickness profile of PECVD films of the buffer material 252 described herein within the TGV opening 192 could also be indicative of a PECVD process if the process consisted of two subsequent one-sided depositions. In this case, there could be a distinct thinning of the film around the center/waist of the TGV.

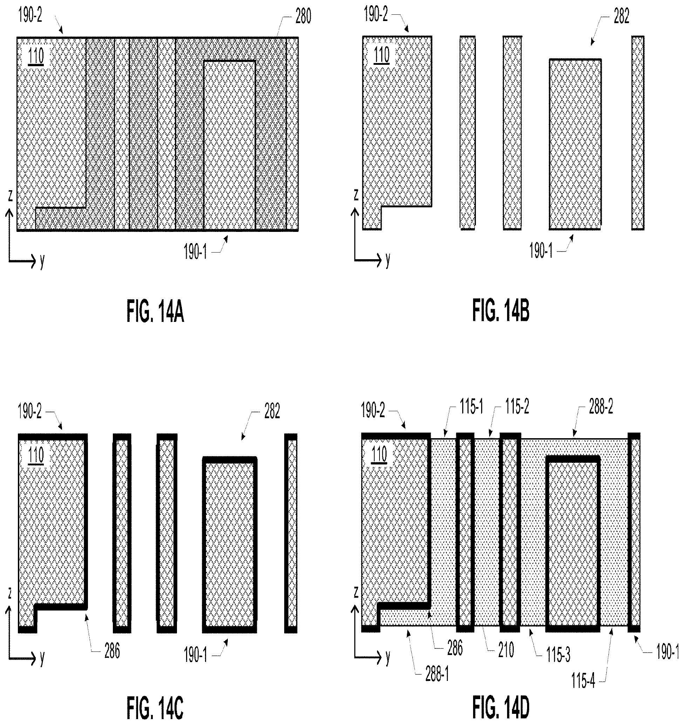

Techniques based on modifying the architecture and arrangement of the TGVs 115 to alleviate TGV stress are shown in FIGS. 12-13, followed by an illustration of glass core patterning to form conductive traces, shown in FIGS. 14A-14D, enabled by the TGV stress alleviation techniques described herein.

FIGS. 12A-12D illustrate TGVs with different patterns of conductive material and TGV stress resist material, according to some embodiments of the present disclosure. In particular, FIG. 12A illustrates a glass core 110 with a TGV 115 extending between the first face 190-1 and the second face 190-2, where the TGV 115 is deliberately made to have an hourglass shape. This may be achieved by, e.g., etching the glass to form half of a TGV opening 192 from the first face 190-1, and then etching the glass to form the other half of the TGV opening 192 from the second face 190-2. With such a shape, it is possible to deposit the conductive material 210 only on the sidewalls 190-4 of the TGV 115, but have gaps in the center of the TGV 115, proximate to the first and second faces 190-1, 190-2, which gaps may then be filled with a filler material 260. To that end, in some embodiments, the conductive material 210 may be deposited within the TGV 115 using any suitable conformal plating technique, so that the TGV opening has the conductive material 210 deposited on the sidewalls 190-4 but not completely filling the opening. Alternatively, in some embodiments, the TGV 115 may first be completely filled with the conductive material 210 and then portions of the conductive material 210 may be removed to form the gaps to be filled with the filler material 260. The filler material 260 may include any suitable TGV stress resist material, e.g., any suitable material that has the CTE smaller than that of the conductive material 210 and can be filled in the openings in the TGV 115 as shown in FIG. 12A. In some embodiments, the filler material 260 may include any of the materials described above as materials with relatively low CTE, such as any of the materials described with reference to the buffer layers 206, 216, 226, 236, 246, and 256. Placing the filler material 260 in the center of the TGV 115 may help reduce anneal stresses and residual stresses imposed on the glass core 110 by reducing radial expansion of the conductive material 210.

FIG. 12A illustrates an embodiment where the conductive material 210 has substantially the same thickness (e.g., a dimension measured perpendicular to the sidewall 190-4) from the first face 190-1 to the second face 190-2 of the glass core 110. On the other hand, FIG. 12B illustrates an embodiment that is similar to that of FIG. 12A, except where the thickness of the conductive material 210 varies between the first face 190-1 and the second face 190-2. In particular, as shown in FIG. 12B, the conductive material 210 may have the greatest thickness substantially in the middle of the TGV 115, e.g., in a portion shown with a line 262-1, but the thickness may taper (i.e., gradually decrease) towards the first face 190-1 and towards the second face 190-2. Thus, the thickness of the conductive material 210 in a portion of the glass core 110 shown in FIG. 12B with a line 262-2 may be smaller than that in the portion shown with the line 262-1, and the thickness of the conductive material 210 in a portion of the glass core 110 shown in FIG. 12B with a line 262-3 may be smaller than that in the portion shown with the line 262-2. Tapered profile of the conductive material 210 may help maintain constant maximum current (Imax) that can flow through a TGV. Embodiment shown in FIG. 12B may allow achieving greater TGV stress reduction than that shown in FIG. 12A, but that may be at the cost of more complex manufacturability. Embodiment shown in FIG. 12A may result in lower TGV stress reduction than that shown in FIG. 12B but may be much simpler to manufacture.

FIGS. 12C and 12D illustrate embodiments similar to those shown in FIGS. 12A and 12B, respectively, but further showing that a buffer layer 266 may be deposited on the sidewalls 190-4 prior to deposition of the conductive material 210. Thus, the buffer layer 266 may be between the glass material of the glass core 110 and the conductive material 210. In various embodiments, the buffer layer 266 may take form of any of the buffer layers 206, 216, 226, 236, 246, and 256, described above. Provision of the buffer layer 266 may help further alleviate the TGV stress.

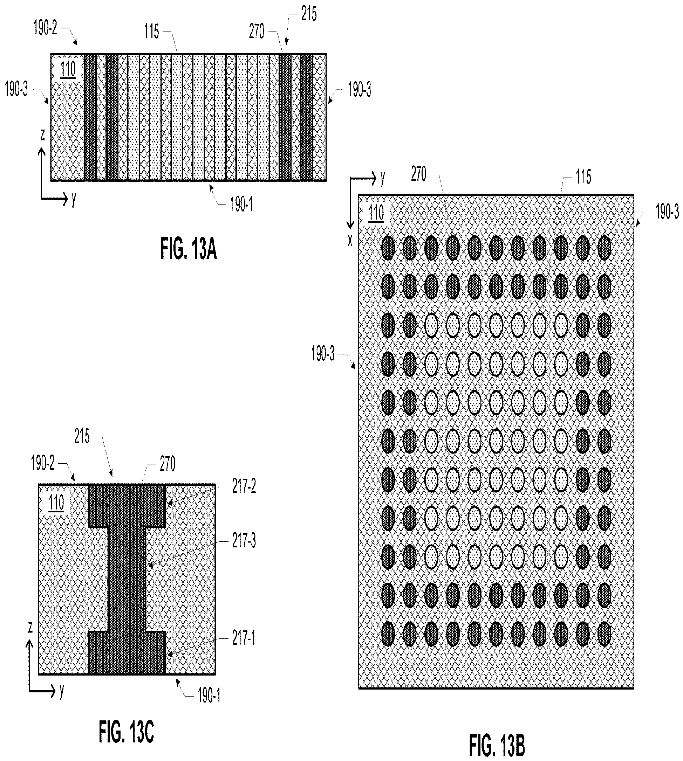

FIGS. 13A-13C illustrate using polymer-filled TGVs to alleviate TGV stress, according to some embodiments of the present disclosure. In particular, FIG. 13A illustrates a glass core 110 with a plurality of TGVs 115 extending between the first face 190-1 and the second face 190-2 and a plurality of compensation TGVs 215 also extending between the first face 190-1 and the second face 190-2. Seven TGVs 115 and four compensation TGVs 215 are shown in FIG. 13A, but, in other embodiments, any other number may be used for either one of these. Any of the TGVs 115 may be a TGV 115 according to any of the embodiments described herein, e.g., according to any embodiments described with reference to FIGS. 4-12. The TGVs 215 may be similar to the TGVs 115 in their shape and dimensions but may be filled with a compensation material 270 having a relatively low CTE without having any substantial portions of the conductive material 210. In some embodiments, the TGVs 215 may be fully filled with the compensation material 270. In other embodiments, the TGVs 215 may be partially filled with the compensation material 270 (e.g., only on sidewalls, e.g., similar to the buffer layers described herein), and have gaps in the center, where the gaps may be left substantially empty (i.e., as voids) or may be filled with some other materials that are not metals. In some embodiments, the compensation material 270 may be in at least 50% or in at least 75% of the volume of a TGV 215. In some embodiments, the TGVs 215 may not include any metals. The compensation material 270 may include any suitable materials that have CTEs smaller than that of the conductive material 210 and can be filled in the openings in the TGVs 215 as shown in FIG. 13A. In some embodiments, the compensation material 270 may include any of the materials described above as materials with relatively low CTE, such as any of the materials described with reference to the buffer layers 206, 216, 226, 236, 246, and 256. In some embodiments, the compensation material 270 may include any of filled and unfilled dielectrics such as polyimide, PBO, acrylic, urethane, silicone, or epoxy-based materials. Using a higher thermal shrinkage material as the compensation material 270 may allow for further compressive force allowing for an improvement in the glass cohesion. In some embodiments, the compensation material 270 may be a material with high tensile strength and high elongation relative to glass, which may help absorb the stress from the materials of the build-up layers that may be placed on the glass core 110 (e.g., build-up layers may then be pulling on the compensation material 270 rather than directly on glass), while also acting as a stiffener, potentially increasing the cohesive forces by pulling the glass together. Filling some of the TGVs in the glass core 110 with only compensation material 270 so that the TGVs 215 are not used for their electrical conductivity (e.g., by not including any conductive materials therein) may allow compensating for the overall TGV stress in the glass core 110 caused by the conductive material 210 in the TGVs 115. Completely filling the TGVs 215 with the compensation material 270 in the form of any suitable polymeric materials may help create stress relieving points within the glass core 110 to reduce or eliminate cracking of the glass core 110. In some implementations, the TGVs 215 may also help increase the cohesive forces of the glass by utilizing resins with high thermal shrinkage.

FIG. 13A illustrates that the TGVs 215 may be placed closer to the sides 190-3 of the glass core 110 in some embodiments. FIG. 13B also illustrates an embodiment with the TGVs 215 close to the periphery of the glass core 110, but showing a top-down view of the glass core 110. However, in other embodiments, locations and arrangements of the TGVs 215, as well as their numbers and the numbers of the TGVs 115, may be different than what is shown in FIGS. 13A and 13B. FIG. 13C further illustrates that the TGVs 215 themselves may be modified in shape to further improve cohesive forces. For example, in some embodiments, the TGVs 215 may have a wider portion 217-1 proximate to the first face 190-1 and/or a wider portion 217-2 proximate to the second face 190-2, and have a narrower portion 217-3 between the portions 217-1 and 217-2 (e.g., substantially in the middle of the glass core 110), as shown in FIG. 13C.

Improvements in TGV stress alleviation according to various embodiments described herein may allow implementing architectures that were not possible before. For example, with conventional organic core substrates, it is not possible to have embedded features such as conductive traces, on the surfaces of the core. It is also not possible to make precise blind features on the core. Therefore, the conventional technologies and previous solutions do not utilize the core layer for creating interconnect/routing layers. All of the routing structures (e.g., conductive traces) are typically included in the build-up layers (e.g., in the layers of the dielectric material 112 above the glass core 110 and in the further layers 111 below the glass core 110 or, more generally, as parts of the substrate 107 above and below the glass core 110, as described with reference to FIG. 1). Each additional layer is an additional cost. Unlike organic substrates, glass cores as described herein, e.g., the glass core 110 could have various conductive features embedded on its back and front surfaces (e.g., on the first and second faces 190-1 and 190-2), where buffer layers as described herein may be used for TGV stress alleviation. One example of this is shown in FIGS. 14A-14D, illustrating cross-sectional side views of a glass core showing a process of glass core patterning to form conductive traces, according to some embodiments of the present disclosure. FIG. 14A illustrates that the process may begin with forming one or more modified regions 280 in a glass core 110. The modified regions 280 may be regions of the glass core 110 that have been modified in a way that makes them etch-selective with respect to the unmodified portions of the glass core 110, so that the modified regions 280 may be removed in a subsequent process to form openings 282 in their place, as is shown in FIG. 14B. In some embodiments, the modified regions 280 may be laser-affected regions of the glass core 110 (i.e., where laser is used to modify material properties in the modifier regions 280 to make them etch-selective with respect to the unmodified portions of the glass core 110). Next, a buffer layer 286 may be deposited on exposed surfaces of the openings 282, as shown in FIG. 14C. In various embodiments, the buffer layer 286 may take form of any of the buffer layers 206, 216, 226, 236, 246, and 256, described above. Finally, the conductive material 210 may be filled in the openings 282 lined with the buffer layer 286, as shown in FIG. 14D. The buffer layer 286 may help alleviate TGV stress between the conductive material 210 and the glass material of the glass core 110, as described above. In this manner, various conductive features may be formed in the glass core 110 such as TGVs 115, individually labeled in FIG. 14D as TGVs 115-1, 115-2, 115-3, and 115-4. Any of the TGVs 115-1, 115-2, 115-3, and 115-4 may be a TGV 115 according to any of the embodiments described herein, e.g., according to any embodiments described with reference to FIGS. 4-12. Besides the TGVs 115, other conductive features may be formed on the faces 190 of the glass core 110, examples of which are shown in FIG. 14D with conductive traces 288, individually labeled in FIG. 14D as conductive traces 288-1 and 288-2. The conductive trace 288-1 may be used to provide electrical routing at the first face 190-1 and the conductive trace 288-2 may be used to provide electrical routing at the first face 190-1, similar to the conductive traces 108A, described above. In some embodiments, one or more conductive traces 288 may be connected (e.g., electrically and materially continuous) with one or more TGVs 115. For example, FIG. 14D illustrates that the conductive trace 288-1 may be connected (e.g., may have materially continuous conductive material 210) with the TGV 115-1, while the conductive trace 288-2 may be connected with the TGV 115-3 at one end and with the TGV 115-4 at the other end. By utilizing the glass core 110 itself for routing as shown with the conductive traces 288 of FIG. 14D as an example, the number of build-up layers (e.g., the number of routing layers in the dielectric material 112 of the substrate 107 shown in FIG. 1) can be reduced. Even if there is not enough empty space on the glass core 110 for a large number of conductive traces, it could still be possible to have some electrical routing on the glass core 110, which would result in less routing needed for the build-up layers. In turn, the extra space in the build-up layers may be used for other purposes, e.g., for implementing dummy metal areas to improve the plating uniformity on these layers.

Various arrangements of the microelectronic assemblies 100 and glass cores 110 as shown in FIGS. 1-14 do not represent an exhaustive set of microelectronic assemblies and glass cores in which various techniques for TGV stress alleviation as described herein may be used, but merely provide some illustrative examples. In particular, the number and positions of various elements shown in FIGS. 1-14 is purely illustrative and, in various other embodiments, other numbers of these elements, provided in other locations relative to one another may be used in accordance with the general architecture considerations described herein. For example, although not specifically shown in the present drawings, in some embodiments, a microelectronic assembly 100 may include a redistribution layer (RDL) between any pair of layers shown in FIG. 1 and FIG. 2, the RDL including a plurality of interconnect structures (e.g., conductive lines and conductive vias) to assist routing of signals and/or power between components. In another example, although also not specifically shown in the present drawings, in some embodiments, a package substrate 102 of a microelectronic assembly 100 may include one or more recesses. In such embodiments, a bottom face of a recess in the package substrate 102 may be provided by the solid material of the package substrate 102. A recess may be formed in a package substrate 102 in any suitable manner (e.g., via three-dimensional printing, laser cutting or drilling the recess into an existing package substrate, etc.). At least a portion of the substrate 107 or the glass core 110 may be positioned over or at least partially in such a recess. In yet another example, features of any one of FIGS. 1-14 may be combined with features of any other one of FIGS. 1-14.

The microelectronic assemblies 100 and/or the glass cores 110 disclosed herein may be included in any suitable electronic component. FIGS. 15-18 illustrate various examples of apparatuses that may include, or be included in, any of the microelectronic assemblies 100 and/or the glass cores 110 disclosed herein.

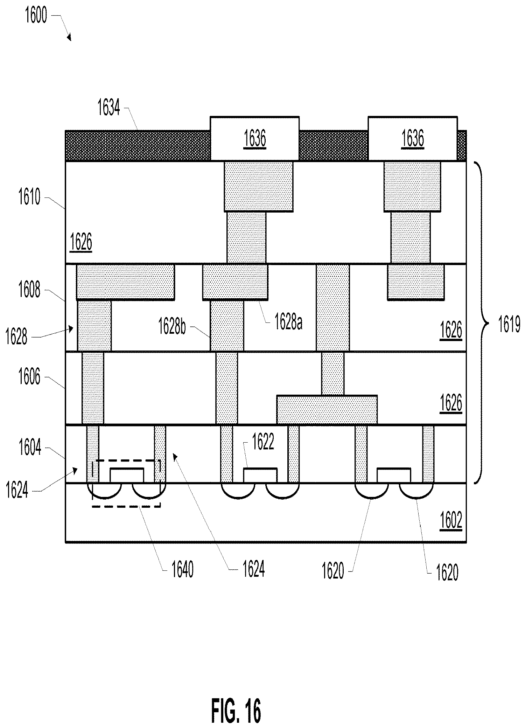

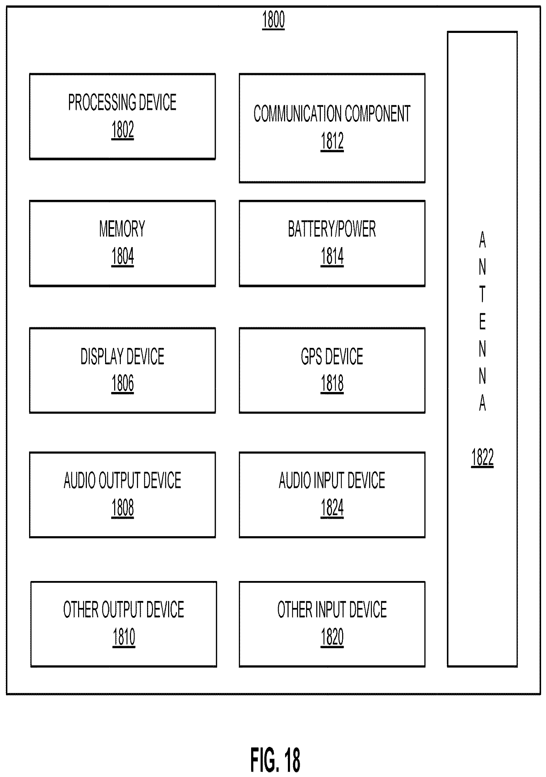

FIG. 15 is a top view of a wafer 1500 and dies 1502 that may be included in any of the microelectronic assemblies 100 as described herein. For example, a die 1502 may be any of the dies 114 described herein. The wafer 1500 may be composed of semiconductor material and may include one or more dies 1502 having IC structures formed on a surface of the wafer 1500. Each of the dies 1502 may be a repeating unit of a semiconductor product that includes any suitable IC. After the fabrication of the semiconductor product is complete, the wafer 1500 may undergo a singulation process in which the dies 1502 are separated from one another to provide discrete "chips" of the semiconductor product. The die 1502 may include one or more transistors (e.g., some of the transistors 1640 of FIG. 16, discussed below) and/or supporting circuitry to route electrical signals to the transistors, as well as any other IC components. In some embodiments, the wafer 1500 or the die 1502 may include a memory device (e.g., a random-access memory (RAM) device, such as a static RAM (SRAM) device, a magnetic RAM (MRAM) device, a resistive RAM (RRAM) device, a conductive-bridging RAM (CBRAM) device, etc.), a logic device (e.g., an AND, OR, NAND, or NOR gate), or any other suitable circuit element. Multiple ones of these devices may be combined on a single die 1502. For example, a memory array formed by multiple memory devices may be formed on a same die 1502 as a processing device (e.g., the processing device 1802 of FIG. 18) or other logic that is configured to store information in the memory devices or execute instructions stored in the memory array.

FIG. 16 is a side, cross-sectional view of an IC device 1600 that may be included in any of the microelectronic assemblies 100 as described herein. For example, an IC device 1600 may be provided on/in any of the dies 114 described herein. The IC device 1600 may be formed on a substrate 1602 (e.g., the wafer 1500 of FIG. 15) and may be included in a die (e.g., the die 1502 of FIG. 15). The substrate 1602 may be a semiconductor substrate composed of semiconductor material systems including, for example, n-type or p-type materials systems (or a combination of both). The substrate 1602 may include, for example, a crystalline substrate formed using a bulk silicon or a silicon-on-insulator (SOI) substructure. In some embodiments, the substrate 1602 may be formed using alternative materials, which may or may not be combined with silicon, that include but are not limited to germanium, indium antimonide, lead telluride, indium arsenide, indium phosphide, gallium arsenide, or gallium antimonide. Further materials classified as group III-V materials (i.e., materials from groups III and V of the periodic system of elements), group II-VI (i.e., materials from groups II and IV of the periodic system of elements), or group IV materials (i.e., materials from group IV of the periodic system of elements) may also be used to form the substrate 1602. Although a few examples of materials from which the substrate 1602 may be formed are described here, any material that may serve as a foundation for an IC device 1600 may be used. The substrate 1602 may be part of a singulated die (e.g., the dies 1502 of FIG. 15) or a wafer (e.g., the wafer 1500 of FIG. 15).

The IC device 1600 may include one or more device layers 1604 disposed on the substrate 1602. The device layer 1604 may include features of one or more transistors 1640 (e.g., metal oxide semiconductor field-effect transistors (MOSFETs)) formed on the substrate 1602. The device layer 1604 may include, for example, one or more source and/or drain (S/D) regions 1620, a gate 1622 to control current flow in the transistors 1640 between the S/D regions 1620, and one or more S/D contacts 1624 to route electrical signals to/from the S/D regions 1620. The transistors 1640 may include additional features not depicted for the sake of clarity, such as device isolation regions, gate contacts, and the like. The transistors 1640 are not limited to the type and configuration depicted in FIG. 16 and may include a wide variety of other types and configurations such as, for example, planar transistors, non-planar transistors, or a combination of both. Planar transistors may include bipolar junction transistors (BJT), heterojunction bipolar transistors (HBT), or high-electron-mobility transistors (HEMT). Non-planar transistors may include FinFET transistors, such as double-gate transistors or tri-gate transistors, and wrap-around or all-around gate transistors, such as nanoribbon and nanowire transistors.

Each transistor 1640 may include a gate 1622 formed of at least two layers, a gate dielectric and a gate electrode. The gate dielectric may include one layer or a stack of layers. The one or more layers may include silicon oxide, silicon dioxide, silicon carbide, and/or a high-k dielectric material. The high-k dielectric material may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some embodiments, an annealing process may be carried out on the gate dielectric to improve its quality when a high-k material is used.

The gate electrode may be formed on the gate dielectric and may include at least one p-type work function metal or n-type work function metal, depending on whether the transistor 1640 is to be a p-type metal oxide semiconductor (PMOS) or an n-type metal oxide semiconductor (NMOS) transistor. In some implementations, the gate electrode may consist of a stack of two or more metal layers, where one or more metal layers are work function metal layers and at least one metal layer is a fill metal layer. Further metal layers may be included for other purposes, such as a barrier layer. For a PMOS transistor, metals that may be used for the gate electrode include, but are not limited to, ruthenium, palladium, platinum, cobalt, nickel, conductive metal oxides (e.g., ruthenium oxide), and any of the metals discussed below with reference to an NMOS transistor (e.g., for work function tuning). For an NMOS transistor, metals that may be used for the gate electrode include, but are not limited to, hafnium, zirconium, titanium, tantalum, aluminum, alloys of these metals, carbides of these metals (e.g., hafnium carbide, zirconium carbide, titanium carbide, tantalum carbide, and aluminum carbide), and any of the metals discussed above with reference to a PMOS transistor (e.g., for work function tuning).

In some embodiments, when viewed as a cross-section of the transistor 1640 along the source-channel-drain direction, the gate electrode may consist of a U-shaped structure that includes a bottom portion substantially parallel to the surface of the substrate and two sidewall portions that are substantially perpendicular to the top face of the substrate. In other embodiments, at least one of the metal layers that form the gate electrode may simply be a planar layer that is substantially parallel to the top face of the substrate and does not include sidewall portions substantially perpendicular to the top face of the substrate. In other embodiments, the gate electrode may consist of a combination of U-shaped structures and planar, non-U-shaped structures. For example, the gate electrode may consist of one or more U-shaped metal layers formed atop one or more planar, non-U-shaped layers.

In some embodiments, a pair of sidewall spacers may be formed on opposing sides of the gate stack to bracket the gate stack. The sidewall spacers may be formed from materials such as silicon nitride, silicon oxide, silicon carbide, silicon nitride doped with carbon, and silicon oxynitride. Processes for forming sidewall spacers are well known in the art and generally include deposition and etching process steps. In some embodiments, a plurality of spacer pairs may be used; for instance, two pairs, three pairs, or four pairs of sidewall spacers may be formed on opposing sides of the gate stack.

The S/D regions 1620 may be formed within the substrate 1602 adjacent to the gate 1622 of each transistor 1640. The S/D regions 1620 may be formed using an implantation/diffusion process or an etching/deposition process, for example. In the former process, dopants such as boron, aluminum, antimony, phosphorous, or arsenic may be ion-implanted into the substrate 1602 to form the S/D regions 1620. An annealing process that activates the dopants and causes them to diffuse farther into the substrate 1602 may follow the ion-implantation process. In the latter process, the substrate 1602 may first be etched to form recesses at the locations of the S/D regions 1620. An epitaxial deposition process may then be carried out to fill the recesses with material that is used to fabricate the S/D regions 1620. In some implementations, the S/D regions 1620 may be fabricated using a silicon alloy such as silicon germanium or silicon carbide. In some embodiments, the epitaxially deposited silicon alloy may be doped in situ with dopants such as boron, arsenic, or phosphorous. In some embodiments, the S/D regions 1620 may be formed using one or more alternate semiconductor materials such as germanium or a group III-V material or alloy. In further embodiments, one or more layers of metal and/or metal alloys may be used to form the S/D regions 1620.

Electrical signals, such as power and/or input/output (I/O) signals, may be routed to and/or from the devices (e.g., the transistors 1640) of the device layer 1604 through one or more interconnect layers disposed on the device layer 1604 (illustrated in FIG. 16 as interconnect layers 1606, 1608, and 1610). For example, electrically conductive features of the device layer 1604 (e.g., the gate 1622 and the S/D contacts 1624) may be electrically coupled with the interconnect structures 1628 of the interconnect layers 1606, 1608, and 1610. The one or more interconnect layers 1606, 1608, and 1610 may form a metallization stack (also referred to as an "ILD stack") 1619 of the IC device 1600.

The interconnect structures 1628 may be arranged within the interconnect layers 1606-1610 to route electrical signals according to a wide variety of designs (in particular, the arrangement is not limited to the particular configuration of interconnect structures 1628 depicted in FIG. 16). Although a particular number of interconnect layers 1606, 1608, and 1610 is depicted in FIG. 16, embodiments of the present disclosure include IC devices having more or fewer interconnect layers than depicted.

In some embodiments, the interconnect structures 1628 may include lines 1628a and/or vias 1628b filled with an electrically conductive material such as a metal. The lines 1628a may be arranged to route electrical signals in a direction of a plane that is substantially parallel with a surface of the substrate 1602 upon which the device layer 1604 is formed. For example, the lines 1628a may route electrical signals in a direction in and out of the page from the perspective of FIG. 16. The vias 1628b may be arranged to route electrical signals in a direction of a plane that is substantially perpendicular to the surface of the substrate 1602 upon which the device layer 1604 is formed. In some embodiments, the vias 1628b may electrically couple lines 1628a of different interconnect layers 1606, 1608, and 1610 together.

The interconnect layers 1606, 1608, and 1610 may include a dielectric material 1626 disposed between the interconnect structures 1628, as shown in FIG. 16. In some embodiments, the dielectric material 1626 disposed between the interconnect structures 1628 in different ones of the interconnect layers 1606, 1608, and 1610 may have different compositions; in other embodiments, the composition of the dielectric material 1626 between different interconnect layers 1606, 1608, and 1610 may be the same.

A first interconnect layer 1606 may be formed above the device layer 1604. In some embodiments, the first interconnect layer 1606 may include lines 1628a and/or vias 1628b, as shown. The lines 1628a of the first interconnect layer 1606 may be coupled with contacts (e.g., the S/D contacts 1624) of the device layer 1604.

A second interconnect layer 1608 may be formed above the first interconnect layer 1606. In some embodiments, the second interconnect layer 1608 may include vias 1628b to couple the lines 1628a of the second interconnect layer 1608 with the lines 1628a of the first interconnect layer 1606. Although the lines 1628a and the vias 1628b are structurally delineated with a line within each interconnect layer (e.g., within the second interconnect layer 1608) for the sake of clarity, the lines 1628a and the vias 1628b may be structurally and/or materially contiguous (e.g., simultaneously filled during a dual-damascene process) in some embodiments.

A third interconnect layer 1610 (and additional interconnect layers, as desired) may be formed in succession on the second interconnect layer 1608 according to similar techniques and configurations described in connection with the second interconnect layer 1608 or the first interconnect layer 1606. In some embodiments, the interconnect layers that are "higher up" in the metallization stack 1619 in the IC device 1600 (i.e., farther away from the device layer 1604) may be thicker.

The IC device 1600 may include a solder resist material 1634 (e.g., polyimide or similar material) and one or more conductive contacts 1636 formed on the interconnect layers 1606, 1608, and 1610. In FIG. 16, the conductive contacts 1636 are illustrated as taking the form of bond pads. The conductive contacts 1636 may be electrically coupled with the interconnect structures 1628 and configured to route the electrical signals of the transistor(s) 1640 to other external devices. For example, solder bonds may be formed on the one or more conductive contacts 1636 to mechanically and/or electrically couple a chip including the IC device 1600 with another component (e.g., a circuit board). The IC device 1600 may include additional or alternate structures to route the electrical signals from the interconnect layers 1606, 1608, and 1610; for example, the conductive contacts 1636 may include other analogous features (e.g., posts) that route the electrical signals to external components.

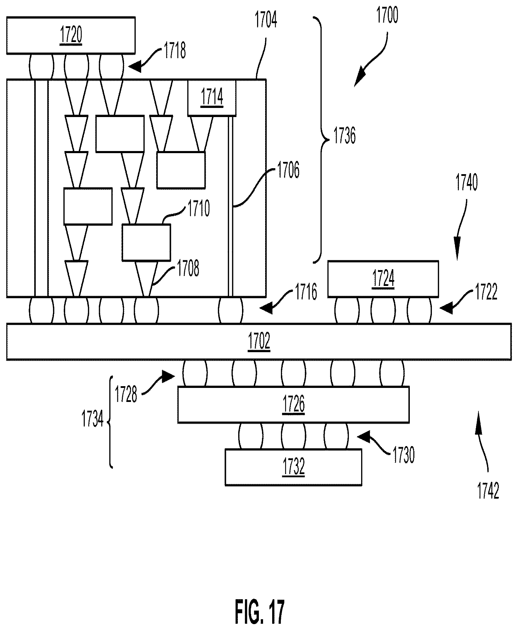

FIG. 17 is a side, cross-sectional view of an IC device assembly 1700 that may include a glass core with TGV stress alleviation in accordance with any of the embodiments disclosed herein. The IC device assembly 1700 includes a number of components disposed on a circuit board 1702 (which may be, e.g., a motherboard). The IC device assembly 1700 includes components disposed on a first face 1740 of the circuit board 1702 and an opposing second face 1742 of the circuit board 1702; generally, components may be disposed on one or both faces 1740 and 1742. Any of the IC packages discussed below with reference to the IC device assembly 1700 may take the form of any of the embodiments of the microelectronic assemblies 100 discussed above, e.g., may include one or more microelectronic assemblies 100 as discussed with reference to FIG. 1 and FIG. 2, and/or may include one or more glass cores as discussed with reference to FIGS. 3-14.

In some embodiments, the circuit board 1702 may be a PCB including multiple metal layers separated from one another by layers of dielectric material and interconnected by electrically conductive vias. Any one or more of the metal layers may be formed in a desired circuit pattern to route electrical signals (optionally in conjunction with other metal layers) between the components coupled to the circuit board 1702. In other embodiments, the circuit board 1702 may be a non-PCB substrate.

The IC device assembly 1700 illustrated in FIG. 17 includes a package-on-interposer structure 1736 coupled to the first face 1740 of the circuit board 1702 by coupling components 1716. The coupling components 1716 may electrically and mechanically couple the package-on-interposer structure 1736 to the circuit board 1702, and may include solder balls (as shown in FIG. 17), male and female portions of a socket, an adhesive, an underfill material, and/or any other suitable electrical and/or mechanical coupling structure.

The package-on-interposer structure 1736 may include an IC package 1720 coupled to a package interposer 1704 by coupling components 1718. The coupling components 1718 may take any suitable form for the application, such as the forms discussed above with reference to the coupling components 1716. Although a single IC package 1720 is shown in FIG. 17, multiple IC packages may be coupled to the package interposer 1704; indeed, additional interposers may be coupled to the package interposer 1704. The package interposer 1704 may provide an intervening substrate used to bridge the circuit board 1702 and the IC package 1720. The IC package 1720 may be or include, for example, a die (the die 1502 of FIG. 5), an IC device (e.g., any of the IC devices described herein, or any combination of such IC devices), or any other suitable component. Generally, the package interposer 1704 may spread a connection to a wider pitch or reroute a connection to a different connection. For example, the package interposer 1704 may couple the IC package 1720 (e.g., a die) to a set of ball grid array (BGA) conductive contacts of the coupling components 1716 for coupling to the circuit board 1702. In the embodiment illustrated in FIG. 17, the IC package 1720 and the circuit board 1702 are attached to opposing sides of the package interposer 1704; in other embodiments, the IC package 1720 and the circuit board 1702 may be attached to a same side of the package interposer 1704. In some embodiments, three or more components may be interconnected by way of the package interposer 1704.

In some embodiments, the package interposer 1704 may be formed as a glass core with TGV stress alleviation, e.g., as any embodiment of the glass core 110, described herein. In some embodiments, the package interposer 1704 may be formed as a PCB. In some embodiments, the package interposer 1704 may be formed of an epoxy resin, a fiberglass-reinforced epoxy resin, an epoxy resin with inorganic fillers, a ceramic material, or a polymer material such as polyimide. In some embodiments, the package interposer 1704 may be formed of alternate rigid or flexible materials that may include the same materials described above for use in a semiconductor substrate, such as silicon, germanium, and other group III-V and group IV materials. In any of these embodiments, the package interposer 1704 may include multiple metal layers separated from one another by layers of dielectric material and interconnected by electrically conductive vias. The package interposer 1704 may include metal lines 1710 and vias 1708, including but not limited to conductive vias 1706. If the package interposer 1704 is a glass core, e.g., the glass core 110 as described herein, then the conductive vias 1706 may be TGVs with stress alleviation as described herein. The package interposer 1704 may further include embedded devices 1714, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as RF devices, power amplifiers, power management devices, antennas, arrays, sensors, and microelectromechanical systems (MEMS) devices may also be formed on the package interposer 1704. The package-on-interposer structure 1736 may take the form of any of the package-on-interposer structures known in the art.

The IC device assembly 1700 may include an IC package 1724 coupled to the first face 1740 of the circuit board 1702 by coupling components 1722. The coupling components 1722 may take the form of any of the embodiments discussed above with reference to the coupling components 1716, and the IC package 1724 may take the form of any of the embodiments discussed above with reference to the IC package 1720.

The IC device assembly 1700 illustrated in FIG. 17 includes a package-on-package structure 1734 coupled to the second face 1742 of the circuit board 1702 by coupling components 1728. The package-on-package structure 1734 may include an IC package 1726 and an IC package 1732 coupled together by coupling components 1730 such that the IC package 1726 is disposed between the circuit board 1702 and the IC package 1732. The coupling components 1728 and 1730 may take the form of any of the embodiments of the coupling components 1716 discussed above, and the IC packages 1726 and 1732 may take the form of any of the embodiments of the IC package 1720 discussed above. The package-on-package structure 1734 may be configured in accordance with any of the package-on-package structures known in the art.

FIG. 18 is a block diagram of an example communication device 1800 that may include one or more microelectronic assemblies 100 and/or one or more glass cores 110 in accordance with any of the embodiments disclosed herein. A handheld communication device or a laptop communication device may be examples of the communication device 1800. Any suitable ones of the components of the communication device 1800 may include one or more of the microelectronic assemblies 100, IC packages 1720, 1724, IC device assemblies 1700, IC devices 1600, or dies 1502 disclosed herein. In particular, any suitable ones of the components of the communication device 1800 may include one or more glass cores 110 as described herein, e.g., as a part of a microelectronic assembly 100 as described herein. A number of components are illustrated in FIG. 18 as included in the communication device 1800, but any one or more of these components may be omitted or duplicated, as suitable for the application. In some embodiments, some or all of the components included in the communication device 1800 may be attached to one or more motherboards. In some embodiments, some or all of these components are fabricated onto a single system-on-a-chip (SoC) die.

Additionally, in various embodiments, the communication device 1800 may not include one or more of the components illustrated in FIG. 18, but the communication device 1800 may include interface circuitry for coupling to the one or more components. For example, the communication device 1800 may not include a display device 1806, but may include display device interface circuitry (e.g., a connector and driver circuitry) to which a display device 1806 may be coupled. In another set of examples, the communication device 1800 may not include an audio input device 1824 or an audio output device 1808, but may include audio input or output device interface circuitry (e.g., connectors and supporting circuitry) to which an audio input device 1824 or audio output device 1808 may be coupled.

The communication device 1800 may include a processing device 1802 (e.g., one or more processing devices). As used herein, the term "processing device" or "processor" may refer to any device or portion of a device that processes electronic data from registers and/or memory to transform that electronic data into other electronic data that may be stored in registers and/or memory. The processing device 1802 may include one or more digital signal processors (DSPs), application-specific integrated circuits (ASICs), central processing units (CPUs), graphics processing units (GPUs), cryptoprocessors (specialized processors that execute cryptographic algorithms within hardware), server processors, or any other suitable processing devices. The communication device 1800 may include a memory 1804, which may itself include one or more memory devices such as volatile memory (e.g., dynamic RAM (DRAM)), nonvolatile memory (e.g., read-only memory (ROM)), flash memory, solid state memory, and/or a hard drive. In some embodiments, the memory 1804 may include memory that shares a die with the processing device 1802. This memory may be used as cache memory and may include embedded DRAM (eDRAM) or spin transfer torque magnetic RAM (STT-MRAM).

In some embodiments, the communication device 1800 may include a communication module 1812 (e.g., one or more communication modules). For example, the communication module 1812 may be configured for managing wireless communications for the transfer of data to and from the communication device 1800. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not. The communication module 1812 may be, or may include, any of the microelectronic assemblies 100 disclosed herein.

The communication module 1812 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultra mobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication module 1812 may operate in accordance with a Global System for Mobile Communication (GSM), General Packet Radio Service (GPRS), Universal Mobile Telecommunications System (UMTS), High-Speed Packet Access (HSPA), Evolved HSPA (E-HSPA), or LTE network. The communication module 1812 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication module 1812 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication module 1812 may operate in accordance with other wireless protocols in other embodiments. The communication device 1800 may include an antenna 1822 to facilitate wireless communications and/or to receive other wireless communications (such as AM or FM radio transmissions). The antenna 1822 may include one or more microelectronic assemblies 100 and/or one or more glass cores 110 as described herein, e.g., as a part of a microelectronic assembly 100 as described herein.

In some embodiments, the communication module 1812 may manage wired communications, such as electrical, optical, or any other suitable communication protocols (e.g., the Ethernet). As noted above, the communication module 1812 may include multiple communication modules. For instance, a first communication module 1812 may be dedicated to shorter-range wireless communications such as Wi-Fi or Bluetooth, and a second communication module 1812 may be dedicated to longer-range wireless communications such as global positioning system (GPS), EDGE, GPRS, CDMA, WiMAX, LTE, EV-DO, or others. In some embodiments, a first communication module 1812 may be dedicated to wireless communications, and a second communication module 1812 may be dedicated to wired communications. In some embodiments, the communication module 1812 may support millimeter wave communication.

The communication device 1800 may include battery/power circuitry 1814. The battery/power circuitry 1814 may include one or more energy storage devices (e.g., batteries or capacitors) and/or circuitry for coupling components of the communication device 1800 to an energy source separate from the communication device 1800 (e.g., AC line power).

The communication device 1800 may include a display device 1806 (or corresponding interface circuitry, as discussed above). The display device 1806 may include any visual indicators, such as a heads-up display, a computer monitor, a projector, a touchscreen display, a liquid crystal display (LCD), a light-emitting diode display, or a flat panel display.

The communication device 1800 may include an audio output device 1808 (or corresponding interface circuitry, as discussed above). The audio output device 1808 may include any device that generates an audible indicator, such as speakers, headsets, or earbuds.

The communication device 1800 may include an audio input device 1824 (or corresponding interface circuitry, as discussed above). The audio input device 1824 may include any device that generates a signal representative of a sound, such as microphones, microphone arrays, or digital instruments (e.g., instruments having a musical instrument digital interface (MIDI) output).

The communication device 1800 may include a GPS device 1818 (or corresponding interface circuitry, as discussed above). The GPS device 1818 may be in communication with a satellite-based system and may receive a location of the communication device 1800, as known in the art.

The communication device 1800 may include an other output device 1810 (or corresponding interface circuitry, as discussed above). Examples of the other output device 1810 may include an audio codec, a video codec, a printer, a wired or wireless transmitter for providing information to other devices, or an additional storage device.

The communication device 1800 may include an other input device 1820 (or corresponding interface circuitry, as discussed above). Examples of the other input device 1820 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

The communication device 1800 may have any desired form factor, such as a handheld or mobile communication device (e.g., a cell phone, a smart phone, a mobile internet device, a music player, a tablet computer, a laptop computer, a netbook computer, an ultrabook computer, a personal digital assistant (PDA), an ultra mobile personal computer, etc.), a desktop communication device, a server or other networked computing component, a printer, a scanner, a monitor, a set-top box, an entertainment control unit, a vehicle control unit, a digital camera, a digital video recorder, or a wearable communication device. In some embodiments, the communication device 1800 may be any other electronic device that processes data.

The following paragraphs provide examples of various ones of the embodiments disclosed herein.

Example 1 provides a microelectronic assembly, including a glass core (e.g., a layer of glass comprising a rectangular prism volume) having a first face and a second face opposite the first face, and including a TGV extending between the first face and the second face, where the TGV includes a conductive material and a buffer layer between the conductive material and the glass core, wherea CTE of the buffer layer is smaller than a CTE of the conductive material.

Example 2 provides the microelectronic assembly according to example 1, where the buffer layer includes silicon and oxygen.

Example 3 provides the microelectronic assembly according to example 1, where the buffer layer includes silicon, oxygen, and carbon.

Example 4 provides the microelectronic assembly according to example 1, where the buffer layer includes silicon, oxygen, carbon, and hydrogen.

Example 5 provides the microelectronic assembly according to any one of the preceding examples, where the buffer layer includes an organosilicate film.

Example 6 provides the microelectronic assembly according to any one of the preceding examples, where a thickness of the buffer layer is between about 250 nanometers and about 20 microns.

Example 7 provides the microelectronic assembly according to example 1, where the buffer layer includes a cationic polyelectrolyte.

Example 8 provides the microelectronic assembly according to example 7, where the cationic polyelectrolyte includes poly(diallyldimethylammonium chloride) (PDDA) or polyethylenimine.

Example 9 provides the microelectronic assembly according to any one of examples 7-8, where a thickness of the cationic polyelectrolyte is between about 1 nanometer and about 500 nanometers.

Example 10 provides the microelectronic assembly according to any one of examples 7-9, where the buffer layer further includes an anionic polyelectrolyte.

Example 11 provides the microelectronic assembly according to example 10, where the anionic polyelectrolyte includes polystyrene sulfonate (PSS) or sulfonated polysuflone (SPS).

Example 12 provides the microelectronic assembly according to any one of examples 10-11, where a thickness of the anionic polyelectrolyte is between about 1 nanometer and about 500 nanometers.

Example 13 provides the microelectronic assembly according to any one of examples 10-12, where the buffer layer is a multi-layer structure including a first layer and a second layer, the first layer includes the cationic polyelectrolyte, the second layer includes the anionic polyelectrolyte, and the first layer is between the glass core and the second layer.

Example 14 provides the microelectronic assembly according to example 13, where the second layer is between the first layer and the conductive material.

Example 15 provides the microelectronic assembly according to example 14, where the second layer is in contact with the conductive material.

Example 16 provides the microelectronic assembly according to any one of examples 13-15, where the multi-layer structure further includes a third layer, the third layer includes the cationic polyelectrolyte, and the third layer is between the second layer and the conductive material.

Example 17 provides the microelectronic assembly according to example 16, where the multi-layer structure further includes a fourth layer, the fourth layer includes the anionic polyelectrolyte, and the fourth layer is between the third layer and the conductive material.

Example 18 provides the microelectronic assembly according to example 1, where the buffer layer includes a cationic rr-conjugated oligomer.

Example 19 provides the microelectronic assembly according to example 1, where the cationic polyelectrolyte includes a cationic rr-conjugated polymer.

Example 20 provides the microelectronic assembly according to example 1, where the cationic polyelectrolyte includes a cationic rr-conjugated oligomer and a cationic rr-conjugated polymer.

Example 21 provides the microelectronic assembly according to example 1, where the buffer layer includes a porous polymer structure.

Example 22 provides the microelectronic assembly according to example 21, where the buffer layer includes polytetrafluoroethylene (PTFE).

Example 23 provides the microelectronic assembly according to any one of examples 21-22, where the buffer layer further includes a liner including ABF.

Example 24 provides the microelectronic assembly according to example 23, where a thickness of the liner is between about 1 micron and about 10 microns.

Example 25 provides the microelectronic assembly according to any one of examples 21-24, where a Poisson's ratio of the buffer layer is smaller than about 0.25.

Example 26 provides the microelectronic assembly according to any one of examples 21-25, where a Young's modulus of the buffer layer is smaller than about 10 GPa.

Example 27 provides the microelectronic assembly according to example 1, where the buffer layer includes a metal alkoxide.

Example 28 provides the microelectronic assembly according to example 27, where the buffer layer includes an aluminate, a titanate, or a zirconate.

Example 29 provides the microelectronic assembly according to example 1, where the buffer layer includes a non-metal alkoxide.

Example 30 provides the microelectronic assembly according to example 29, where the buffer layer includes an alkoxysilane.

Example 31 provides the microelectronic assembly according to examples 29 or 30, where the buffer layer includes at least one of a tetramethoxysilane, a tetraethoxysilane, a tetrapropoxysilane, a triethoxy(octyl)silane, a trimethoxymethylsilane, a trimethoxyphenylsilane, or an allyltrimethoxysilane.

Example 32 provides the microelectronic assembly according to any one of examples 27-31, where a Poisson's ratio of the buffer layer is smaller than about 0.25.

Example 33 provides the microelectronic assembly according to any one of examples 27-32, where a Young's modulus of the buffer layer is smaller than about 10 GPa.

Example 34 provides the microelectronic assembly according to example 1, where the buffer layer includes a matrix including a monomer, an oligomer, or a polymer, and further includes particles embedded in the matrix.

Example 35 provides the microelectronic assembly according to example 34, where the particles include one or more inorganic materials.

Example 36 provides the microelectronic assembly according to any one of examples 34-35, where the particles include silicon (e.g., silicon oxide).

Example 37 provides the microelectronic assembly according to any one of examples 34-36, where the particles include aluminum (e.g., aluminum oxide).

Example 38 provides the microelectronic assembly according to any one of examples 34-37, where the particles include zinc (e.g., zinc oxide) or titanium (e.g., titanium oxide).

Example 39 provides the microelectronic assembly according to any one of examples 34-38, where a concentration of the particles decreases in a direction from the conductive material to the glass core.

Example 40 provides the microelectronic assembly according to any one of examples 34-39, where a concentration of the particles is highest at an interface between the buffer layer and the conductive material.

Example 41 provides the microelectronic assembly according to example 1, where the buffer layer includes PTFE, poly(1,3,5-trimethyl-1,3,5-trivinyl cyclotrisiloxane) (pV3D3), poly(1,3,5,7-tetravinyl-1,3,5,7-tetramethylcyclotetrasiloxane) (pV4D4), or pPFDA (poly(1H,1H,2H,2H-perfluorodecyl acrylate).

Example 42 provides the microelectronic assembly according to example 41, where the buffer layer further includes tert-butyl peroxide (TBPO for PGMA) or perfluoro butane sulfonyl fluoride (PBSF).

Example 43 provides the microelectronic assembly according to example 1, where the buffer layer includes one or more of trifluoromethyl groups.

Example 44 provides the microelectronic assembly according to example 1, where the buffer layer includes one or more of carbonyl groups.

Example 45 provides the microelectronic assembly according to example 1, where the buffer layer includes one or more of sulfonyl groups.

Example 46 provides the microelectronic assembly according to any one of the preceding examples, further including a conductive trace in a recess at the first face of the glass core.

Example 47 provides the microelectronic assembly according to example 46, where the conductive trace includes the conductive material and the buffer layer between the conductive material and the glass core.

Example 48 provides the microelectronic assembly according to example 47, where the conductive material of the conductive trace is materially continuous with the conductive material of the TGV.

Example 49 provides the microelectronic assembly according to examples 47 or 48, where the buffer layer of the conductive trace is materially continuous with the buffer layer of the TGV.

Example 50 provides the microelectronic assembly according to any one of examples 46-49, further including the buffer layer at the first face of the glass core.

Example 51 provides the microelectronic assembly according to any one of the preceding examples, where the TGV further includes a filler material, and where the conductive material is between the buffer layer and the filler material.

Example 52 provides the microelectronic assembly according to example 51, wherea CTE of the filler material is smaller than a CTE of the conductive material.

Example 53 provides the microelectronic assembly according to any one of examples 51-53, wherea CTE of the filler material is smaller than about 15 ppm/K.

Example 54 provides the microelectronic assembly according to any one of examples 51-54, where a width of the TGV decreases from the first face to a non-zero depth from the first face towards the second face.

Example 55 provides the microelectronic assembly according to example 54, where a thickness of the conductive material on sidewalls of the TGV is substantially constant between the first face and the second face.

Example 56 provides the microelectronic assembly according to example 55, where the non-zero depth is a first non-zero depth, and where the width of the TGV decreases from the second face to a second non-zero depth from the second face towards the first face.

Example 57 provides the microelectronic assembly according to example 54, where the non-zero depth is a first non-zero depth, and where the width of the TGV decreases from the second face to a second non-zero depth from the second face towards the first face.

Example 58 provides the microelectronic assembly according to example 54, where a thickness of the conductive material on sidewalls of the TGV increases from the first face to a non-zero depth from the first face towards the second face.

Example 59 provides the microelectronic assembly according to example 58, where the non-zero depth is a first non-zero depth, and where the thickness of the conductive material on the sidewalls of the TGV increases from the second face to a second non-zero depth from the second face towards the first face.

Example 60 provides the microelectronic assembly according to example 59, where the width of the TGV decreases from the second face to the second non-zero depth from the second face towards the first face.

Example 61 provides the microelectronic assembly according to any one of the preceding examples, where: the TGV is a first TGV, the glass core further includes a second TGV extending through the glass core between the first face and the second face, and a compensation material is in at least 50% of the volume of the second TGV.

Example 62 provides the microelectronic assembly according to example 61, where the compensation material is in at least 75% of the volume of the second TGV.

Example 63 provides the microelectronic assembly according to any one of examples 61-62, wherea CTE of the compensation material is smaller than a CTE of the conductive material.

Example 64 provides the microelectronic assembly according to any one of examples 61-63, where the CTE of the compensation material is smaller than about 10 ppm/K.

Example 65 provides the microelectronic assembly according to any one of examples 61-64, where the second TGV is closer to an edge of the glass core than the first TGV.

Example 66 provides the microelectronic assembly according to any one of the preceding examples, wherea CTE of the buffer layer is smaller than about 15 ppm/K.

Example 67 provides the microelectronic assembly according to any one of the preceding examples, wherea CTE of the buffer layer is smaller than about 10 ppm/K.

Example 68 provides the microelectronic assembly according to any one of the preceding examples, where a thickness of the buffer layer is between about 10 nanometers and about 20 microns.

Example 69 provides the microelectronic assembly according to any one of the preceding examples, where the conductive material is a metal or a metal alloy.

Example 70 provides the microelectronic assembly according to any one of the preceding examples, where the conductive material includes one or more of copper, silver, nickel, gold, or aluminum.

Example 71 provides a microelectronic assembly, including a layer of glass including a rectangular prism volume; and a via extending from a first side of the rectangular prism volume to a second side of the rectangular prism volume, the via including a metal, where: the via has a first thickness in a first plane parallel to the first side, a second thickness in a second plane parallel to the first side, and a third thickness in a third plane parallel to the first side, the second plane is between the first plane and the third plane, the second thickness is smaller than the first thickness and the third thickness, the via further includes a filler material, the metal is between the glass of the rectangular prism volume and the filler material, anda CTE of the filler material is smaller than a CTE of the metal.

Example 72 provides the microelectronic assembly according to example 71, where the CTE of the filler material is smaller than about 10 ppm/K.

Example 73 provides the microelectronic assembly according to examples 71 or 72, where: the via includes a first region including the filler material and a second region including the filler material, the filler material in the first region is materially discontinuous from the filler material in the second region.

Example 74 provides the microelectronic assembly according to example 73, where a portion of the first region is in a plane of the first side of the rectangular prism volume, and a portion of the second region is in a plane of the second side of the rectangular prism volume.

Example 75 provides the microelectronic assembly according to any one of examples 71-74, where the metal is on a sidewall of the via.

Example 76 provides the microelectronic assembly according to example 75, where a thickness of the metal on the sidewall of the via is substantially constant between the first side and the second side.

Example 77 provides the microelectronic assembly according to any one of examples 75-76, where the metal on the sidewall of the via a first thickness in the first plane, a second thickness in the second plane, and a third thickness in the third plane, and where the second thickness of the metal is larger than the first thickness of the metal and the third thickness of the metal.

Example 78 provides a microelectronic assembly, including a layer of glass including a rectangular prism volume; a via extending from a first side of the rectangular prism volume to a second side of the rectangular prism volume, the via including a metal; and a conductive trace in a recess at the first side of the rectangular prism volume.

Example 79 provides the microelectronic assembly according to example 78, further including a metal in the conductive trace and in the via.

Example 80 provides the microelectronic assembly according to example 79, where the metal of the conductive trace is materially continuous with the metal of the via.

Example 81 provides the microelectronic assembly according to any one of examples 78-80, further including a buffer layer between the metal in the conductive trace and the rectangular prism volume.

Example 82 provides the microelectronic assembly according to example 81, where the buffer layer includes a polymer.

Example 83 provides the microelectronic assembly according to example 81, where the buffer layer is a buffer layer according to any one of claims 1-70.

Example 84 provides the microelectronic assembly according to any one of the preceding examples, where the glass core is a solid layer of glass.

Example 85 provides the microelectronic assembly according to any one of the preceding examples, where a cross-section of the glass core in a plane perpendicular to a surface of the component is substantially rectangular.

Example 86 provides the microelectronic assembly according to any one of the preceding examples, where a cross-section of the glass core in a plane parallel to a surface of the component is substantially rectangular.

Example 87 provides the microelectronic assembly according to any one of the preceding examples, where the glass core is a layer of glass including at least 23% silicon by weight.

Example 88 provides the microelectronic assembly according to any one of the preceding examples, where the glass core is a layer of glass including at least 26% oxygen by weight.

Example 89 provides the microelectronic assembly according to any one of the preceding examples, where the glass core is a layer of glass including at least 23% silicon by weight and at least 26% oxygen by weight.

Example 90 provides the microelectronic assembly according to any one of the preceding examples, where the glass core is a layer of glass including at least 5% aluminum by weight.

Example 91 provides the microelectronic assembly according to any one of the preceding examples, where the glass core is a layer of glass that does not include an organic adhesive or an organic material.

Example 92 provides the microelectronic assembly according to any one of the preceding examples, where the glass core is a layer of glass having a thickness in a range of 50 um to 1.4 mm, a first length in a range of 10 mm to 250 mm, and a second length in a range of 10 mm to 250 mm, the first length perpendicular to the second length.

Example 93 provides the microelectronic assembly according to any one of the preceding examples, where the glass core is a layer of glass having a thickness in a range of 50 um to 1.4 mm.

Example 94 provides the microelectronic assembly according to any one of the preceding examples, where the glass core is a layer of glass having a first length in a range of 10 mm to 250 mm, and a second length in a range of 10 mm to 250 mm, the first length perpendicular to the second length.

Example 95 provides the microelectronic assembly according to any one of the preceding examples, where the glass core is a layer of glass including a rectangular prism volume.

Example 96 provides the microelectronic assembly according to any one of the preceding examples, where the glass core is a layer of glass including a rectangular prism volume having a first side and a second side perpendicular to the first side, the first side having a length in a range of 10 mm to 250 mm and the second side having a length in a range of 10 mm to 250 mm.

Example 97 provides the microelectronic assembly according to any one of the preceding examples, where the glass core is a layer of glass including a rectangular prism volume and a via extending from a first side of the rectangular prism volume to a second side of the rectangular prism volume, the via including a metal.

The above description of illustrated implementations of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize. These modifications may be made to the disclosure in light of the above detailed description.

## Claims

1. A microelectronic assembly, comprising:
a glass core having a first face and a second face opposite the first face, and including a through-glass via (TGV) extending between the first face and the second face,
wherein the TGV includes a conductive material and a buffer layer between the conductive material and the glass core, wherein a coefficient of thermal expansion (CTE) of the buffer layer is smaller than a CTE of the conductive material.

2. The microelectronic assembly according to claim 1, wherein the buffer layer includes an organosilicate film.

3. The microelectronic assembly according to claim 1 or 2, wherein the buffer layer includes one or more of poly(diallyldimethylammonium chloride), polyethylenimine, polystyrene sulfonate, or sulfonated polysuflone.

4. The microelectronic assembly according to one of the previous claims, wherein the buffer layer is a multi-layer structure comprising a first layer and a second layer, the first layer includes a cationic polyelectrolyte, the second layer includes an anionic polyelectrolyte, the first layer is between the glass core and the second layer, and the second layer is between the first layer and the conductive material.

5. The microelectronic assembly according to one of the previous claims, wherein the buffer layer includes a cationic π-conjugated oligomer or a cationic π-conjugated polymer.

6. The microelectronic assembly according to one of the previous claims, wherein the buffer layer includes a metal alkoxide or a non-metal alkoxide.

7. The microelectronic assembly according to one of the previous claims, wherein the buffer layer includes a matrix comprising a monomer, an oligomer, or a polymer, and further includes particles embedded in the matrix, wherein the particles include one or more inorganic materials, and wherein a concentration of the particles decreases in a direction from the conductive material to the glass core.

8. The microelectronic assembly according to one of the previous claims, wherein the buffer layer includes at least one of a trifluoromethyl group, a carbonyl group, or a sulfonyl group.

9. The microelectronic assembly according to one of the previous claims, wherein the TGV further includes a filler material, the conductive material is between the buffer layer and the filler material, and a CTE of the filler material is smaller than the CTE of the conductive material.

10. The microelectronic assembly according to claim 9, wherein a width of the TGV decreases from the first face to a non-zero depth from the first face towards the second face, and wherein a thickness of the conductive material on sidewalls of the TGV increases from the first face to the non-zero depth from the first face towards the second face.

11. The microelectronic assembly according to one of the previous claims, wherein:
the TGV is a first TGV,
the glass core further includes a second TGV extending between the first face and the second face, and
a compensation material is in at least 75% of a volume of the second TGV, wherein the CTE of the compensation material is smaller than about 10 ppm/K, and wherein the second TGV is closer to an edge of the glass core than the first TGV.

12. A microelectronic assembly, comprising:
a layer of glass comprising a rectangular prism volume; and
a via extending from a first side of the rectangular prism volume to a second side of the rectangular prism volume, the via including a metal,
wherein:
the via has a first thickness in a first plane parallel to the first side, a second thickness in a second plane parallel to the first side, and a third thickness in a third plane parallel to the first side,
the second plane is between the first plane and the third plane,
the second thickness is smaller than the first thickness and the third thickness,
the via further includes a filler material,
the metal is between the glass of the rectangular prism volume and the filler material, and
a coefficient of thermal expansion (CTE) of the filler material is smaller than a CTE of the metal.

13. The microelectronic assembly according to claim 12, wherein:
the via includes a first region comprising the filler material and a second region comprising the filler material,
the filler material in the first region is materially discontinuous from the filler material in the second region,
a portion of the first region is in a plane of the first side of the rectangular prism volume, and
a portion of the second region is in a plane of the second side of the rectangular prism volume.

14. A microelectronic assembly, comprising:
a layer of glass comprising a rectangular prism volume;
a via extending from a first side of the rectangular prism volume to a second side of the rectangular prism volume, the via including a metal; and
a conductive trace in a recess at the first side of the rectangular prism volume.

15. The microelectronic assembly according to claim 14, wherein the metal is further in the conductive trace, and the metal of the conductive trace is materially continuous with the metal of the via.
